# EUROPEAN PATENT SPECIFICATION

(11) **EP 2 762 977 B1**
(45) Date of publication and mention of the grant of the patent: **27.09.2017**
(21) Application number: 12846108.4
(22) Date of filing: 02.11.2012
(51) Int. Cl.: G03F 7/32, G03F 7/00, G03F 7/30, C02F 1/04, C02F 103/40

(54) **METHOD FOR RECYCLING PLATE-MAKING PROCESSING WASTE SOLUTION**
VERFAHREN ZUR WIEDERVERWERTUNG VON ABLAUGEN AUS DER PLATTENHERSTELLUNG
PROCÉDÉ DE RECYCLAGE D'UNE SOLUTION RÉSIDUAIRE DE TRAITEMENT DE FABRICATION DE PLAQUE

(30) Priority: 04.11.2011 JP 2011242463
(43) Date of publication of application: 06.08.2014
(73) Proprietor: FUJIFILM Corporation, Tokyo 106-8620 (JP)
(72) Inventor: KOBAYASHI, Fumikazu, Haibara-gun, Shizuoka 421-0396 (JP); WATANABE, Toshihiro, Haibara-gun, Shizuoka 421-0396 (JP)
(74) Representative: Hoffmann Eitle
(86) International application number: PCT/JP2012/078539
(87) International publication number: WO 2013/065853

(56) References cited:
- WO-A1-2011/037080
- JP-A- H0 534 870
- JP-A- H01 307 755
- JP-A- 2003 255 561
- JP-A- 2005 010 264
- JP-A- 2005 049 465
- JP-A- 2006 323 331
- JP-A- 2010 276 824
- JP-A- 2011 090 282
- US-A1- 2010 081 090

## Description

### Technical Field

The present invention relates to a method of recycling waste liquid from a plate-making process for a planographic printing plate precursor, and particularly relates to a method of recycling plate-making process waste liquid in which a developer liquid containing a specific surfactant is used, in which the generated plate-making process waste liquid is concentrated, and in which the obtained regenerated water is reutilized.

### Background Art

In cases in which photosensitive planographic printing plate precursors are developed using an automatic developing machine, a method has hitherto been adopted which includes supplying a development replenisher liquid to a developer liquid of each step, in order to maintain constant concentrations of components that are lost due to development or passage of time and a constant pH and in order to maintain the performance of the developer liquid. Even when this type of replenishment is performed, all of the developer liquid is discarded as waste in cases in which the developer liquid performance becomes to be outside of acceptable bounds. However, since the plate-making process waste liquid is strongly alkaline, it is practically impossible to discharge the waste liquid to sewers as it is, due to recently strengthened pollution control regulations. Waste liquid processing is accordingly necessary by, for example, plate-making companies installing their own waste liquid processing facilities, or by entrusting processing of the waste liquid to waste liquid processing contractors.

However, methods for entrusting waste liquid processing contractors require a large amount of space to store waste liquid up until the handover occurs, and are, moreover, quite expensive in terms of cost. The installation of waste liquid processing facilities also has problems such as the necessity of quite large initial capital and the necessity of significantly wide space for the installation.

In order to address these issues, for example, Japanese Patent Application Laid-Open (JP-A) No. H05-341535 proposes a method in which warm air is blown into a waste liquid storage tank, and JP-A No. H02-157084 proposes a method in which flocculating flocculation components by neutralizing waste liquid produced from the processing and adding a flocculant.

In the technique of JP-A No. H05-341535, since the amount of evaporation is not large, a long time period is necessary to concentrate the plate-making process waste liquid. Therefore, the effect in terms of decreasing waste liquid is not sufficient. Moreover, the technique does not discuss how to deal with the evaporated water content.

The technique of JP-A No. H02-157084 has a problem in that the cost for processing the waste liquid is large due to the necessity for the flocculant. In the case of a plate-making process waste liquid containing a polymer, there is also a problem in that solids remaining inside an evaporation pot form a viscous matter adhered to the walls of the evaporation pot, thereby readily causing contamination and blocking of pipes of the waste liquid processing equipment.

There is also a proposal for a planographic printing plate-making process waste liquid reduction apparatus that is able to decrease the amount of plate-making process waste liquid discharged, and that facilitates reutilization of water generated during the course of the processing of the plate-making process waste liquid (see, for example, Japanese Patent No. 4,774,124).

From the standpoint of addressing the problem of waste liquid produced from development of a planographic printing plates based on the formulation of a developer liquid for a planographic printing plate, developer liquids containing non-reducing sugars and bases have been proposed (see, for example, JP-ANo. 2011-90282).

WO 2011/037080 describes an apparatus for reducing waste lithographic printing plate developing liquid, which comprises an antifoaming agent tank; a processing liquid tank for storing waste positive lithographic printing plate developing liquid; a first container connected to the antifoaming agent tank and the processing liquid tank and comprises a heating coil for heating and concentrating the waste liquid; a second container that comprises a cooling coil for cooling and condensing the water vapor evaporated from the first container; a compressor and a capillary tube that are connected to the heating coil and the cooling coil so as to configure a heat pump system; a pressure reducing means for reducing the pressures of the first container and the second container, said pressure reducing means comprising a water-jet tank, an aspirator and a water-jet pump; and a cleaning water tank which recovers the water cooled and condensed by the second container and is connected to the water-jet tank. A further document describing an apparatus for reducing water consumption in the development of non-silver salt photosensitive materials is JP H05 34870.

US 2010/081090 describes a process for making a lithographic printing plate, comprising: an exposure step of imagewise exposing a lithographic printing plate precursor that comprises, above a hydrophilic support, a photosensitive layer comprising (A) a compound that generates a radical upon the application of light or heat, (B) a polymer having an aromatic carboxy group in a side chain, (C) a polymerizable compound, and (D) an infrared absorber; and a development processing step using one type of processing liquid, wherein the processing liquid has a pH of 8.5 to 10.8.

### SUMMARY OF INVENTION

### Technical Problem

An object of the present invention is to provide a method of recycling plate-making process waste liquid in which foaming at the time of concentrating plate-making process waste liquid is suppressed, and with which a concentration device can easily be washed without contamination of regenerated water with plate-making process waste liquid, without a significant rise in viscosity during the concentrating, and without precipitation of solids content, even in cases in which a plate-making process is performed continuously for a long time period, and with which the regenerated water obtained can be reutilized, and in which the amount of waste liquid discarded as plate-making process waste liquid is very small. Solution to Problem

The object can be achieved by the following aspects:.
<1> A method of recycling waste liquid from a plate-making process for a planographic printing plate precursor, the method including:
   performing, in an automatic developing machine for developing a photosensitive planographic printing plate precursor after exposure to light, a plate-making process using a development replenisher liquid, the planographic printing plate precursor including a radical-polymerizable image recording layer on a support, the plate-making process including developing a planographic printing plate precursor after exposure to light, the development replenisher liquid including at least one selected from the group consisting of anionic surfactants having a naphthalene skeleton and nonionic surfactants having a naphthalene skeleton at a total content of from 1% by mass to 10% by mass, the development replenisher liquid including no organic solvent having a boiling point within a range of from 100°C to 300°C or including organic solvent having a boiling point within a range of from 100°C to 300°C at a total content of no more than 2% by mass, and the development replenisher liquid having a pH of from 10 to 13;
   concentrating, by evaporating, the plate-making process waste liquid discharged during the plate-making process using a waste liquid concentration device, such that the ratio of the volume of the plate-making process waste liquid after concentration to the volume of the plate-making process waste liquid before concentration is within a range of from 1/10 to 1/2, thereby separating the plate-making process waste liquid into water vapor and a waste liquid concentrate;
   condensing the separated water vapor to obtain regenerated water; and
   using the obtained regenerated water as at least one of diluent water for preparation of the development replenisher liquid for the automatic development machine or rinse water for the automatic developing machine.
<2> The method of recycling plate-making process waste liquid according to <1>, wherein the development replenisher liquid further includes at least one organic acid or at least one salt thereof at a total content of from 0.05% by mass to 5% by mass.
<3> The method of recycling plate-making process waste liquid according to <1> or <2>, wherein the total content of silicate component in the development replenisher liquid is 1% by mass or less.
<4> The method of recycling plate-making process waste liquid according to any one of <1> to <3>, wherein the anionic surfactant having a naphthalene skeleton includes at least one anionic surfactant selected from the group consisting of sulfonic acid salts and sulfuric acid salts.
<5> The method of recycling plate-making process waste liquid according to any one of <1> to <4>, wherein the photosensitive planographic printing plate precursor includes a protective layer provided on the radical-polymerizable image recording layer, and washing of the protective layer with water is further performed in the automatic developing machine prior to the developing.
<6> The method of recycling plate-making process waste liquid according to any one of <1> to <5>, wherein the waste liquid concentration device includes a heating means, and the concentrating, by evaporating, of the plate-making process waste liquid is performed by heating the plate-making process waste liquid using the heating means.
<7> The method of recycling plate-making process waste liquid of <6>, wherein the waste liquid concentration device further includes a pressure reducing means that reduces pressure inside the waste liquid concentration device, and the heating of the plate-making process waste liquid is performed under a condition of reduced pressure.
<8> The method of recycling plate-making process waste liquid of <6> or <7>, wherein the heating means of the waste liquid concentration device includes a heat pump that includes a heat release section and a heat absorption section, and the heating means heats the plate-making process waste liquid at the heat release section of the heat pump to generate water vapor, and cools the water vapor at the heat absorption section of the heat pump.
<9> The method of recycling plate-making process waste liquid according to any one of <1> to <8>, further including recovering a concentrate formed after water vapor is separated from the plate-making process waste liquid, the concentrate having been concentrated by the concentrating by evaporating in the waste liquid concentration device, in a recovery tank by applying pressure to the concentrate using a pump.

In the invention, a development replenisher liquid that includes at least one anionic or nonionic surfactant having a naphthalene skeleton at a total content of from 1% by mass to 10% by mass, and in which the content of organic solvent having a boiling point within a range of from 100°C to 300°C is 2% by mass or lower is used, as a result of which foaming occurring during concentration of plate-making process waste liquid can be suppressed, and contamination of the concentration device and incorporation of plate-making process waste liquid into regenerated water obtained, which are caused by droplets arising with foaming or the like, can be prevented. Due to this, the regenerated water obtained is suitably employed as diluent water for the preparation of the development replenisher liquid or as rinse water.

Here, the term "rinse water" refers to water used for washing of a planographic printing plate after development, and removing processing liquids residual on a surface of a planographic printing plate.

In cases in which a concentration ratio in the concentration by evaporation is set to be within a range of from 1/2 to 1/10 in terms of volume as well as using the development replenisher liquid as described above, a significant increase in the viscosity of the concentrated waste liquid, and precipitation of solid content do not occur. Accordingly, a problem in terms of inability to concentrate the plate-making process waste liquid due to these causes can be avoided, and occurrences of contamination of the concentration device, recovery equipment, or the like can be suppressed; therefore, washing of the concentration device or the like is facilitated to give markedly enhanced maintainability.

We presume that the anionic or nonionic surfactant having a naphthalene skeleton promotes emulsification of solids included in the plate-making process waste liquid. We also presume that the emulsified product obtained using the anionic or nonionic surfactant having a naphthalene skeleton exhibits little increase in viscosity when concentrated, and that precipitation of solid content in the emulsified product is suppressed, and that the emulsified product exhibits little adhesion to the equipment such as the concentration device or the like, and that washing or the like is facilitated thereby.

### Advantageous Effects of Invention

According to the invention, a method of recycling plate-making process waste liquid in which foaming at the time of concentrating plate-making process waste liquid is suppressed, and with which a concentration device can easily be washed without contamination of regenerated water with plate-making process waste liquid, without a significant rise in viscosity during the concentrating, and without precipitation of solids content, even in cases in which a plate-making process is performed continuously for a long time period, and with which the regenerated water obtained can be reutilized, and in which the amount of waste liquid discarded as plate-making process waste liquid is very small.

### BRIEF DESCRIPTION OF DRAWINGS

Fig. 1 is a schematic diagram illustrating flow in an apparatus according to a method of recycling plate-making process waste liquid according to the invention.

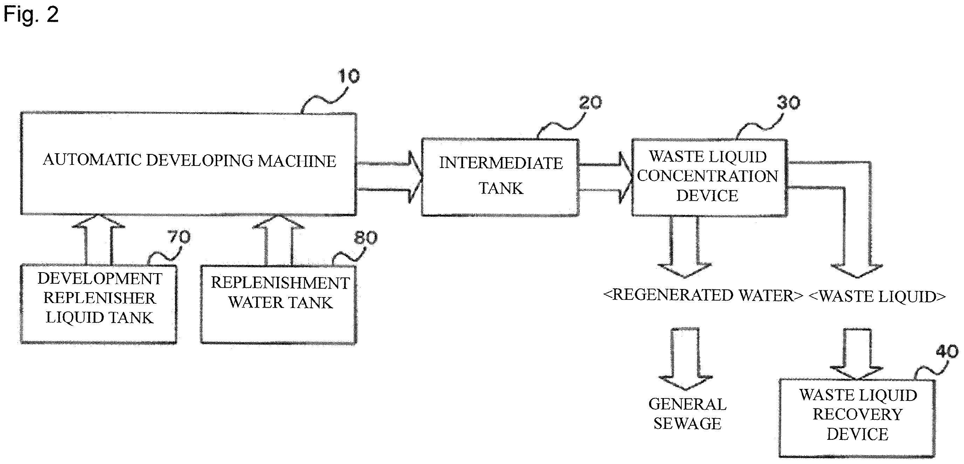

Fig. 2 is a schematic diagram illustrating conventional flow in a development apparatus that includes a concentration device for development process waste liquid.

### DESCRIPTION OF EMBODIMENTS

A method of recycling according to the invention is described in detail below.

The recycling method of recycling waste liquid from a plate-making process for a planographic printing plate precursor according to the invention includes:
performing, in an automatic developing machine for developing a photosensitive planographic printing plate precursor after exposure to light, a plate-making process using a development replenisher liquid, the planographic printing plate precursor including a radical-polymerizable image recording layer on a support, the plate-making process including developing a planographic printing plate precursor after exposure to light, the development replenisher liquid including at least one selected from the group consisting of anionic surfactants having a naphthalene skeleton and nonionic surfactants having a naphthalene skeleton at a total content of from 1% by mass to 10% by mass, the development replenisher liquid including no organic solvent having a boiling point within a range of from 100°C to 300°C or including organic solvent having a boiling point within a range of from 100°C to 300°C at a total content of no more than 2% by mass, and the development replenisher liquid having a pH of from 10 to 13;
concentrating, by evaporating, the plate-making process waste liquid discharged during the plate-making process using a waste liquid concentration device, such that the ratio of the volume of the plate-making process waste liquid after concentration to the volume of the plate-making process waste liquid before concentration is within a range of from 1/10 to 1/2, thereby separating the plate-making process waste liquid into water vapor and a waste liquid concentrate;
condensing the separated water vapor to obtain regenerated water; and
using the obtained regenerated water as at least one of diluent water for preparation of the development replenisher liquid for the automatic development machine or rinse water for the automatic developing machine.

As used herein, the "photosensitive planographic printing plate precursor" means a planographic printing plate precursor having an unexposed photosensitive image recording layer. Planographic printing plate precursors that have an already-exposed image recording layer no longer have photosensitivity, and are therefore simply referred to as "planographic printing plate precursors". Exposure to light, development, and other processes for obtaining the planographic printing plate applied to printing from the photosensitive planographic printing plate precursor, are collectively referred to as "plate-making processes". In the present specification, the development process is a process included in the scope of the plate-making processes.

An example of embodiments according to the invention is described below with reference to the drawings.

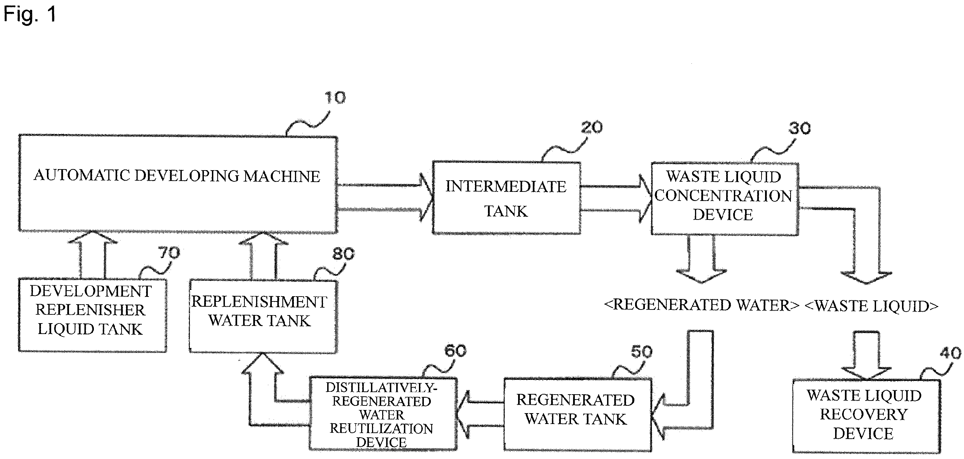

As illustrated in Fig. 1, in the method of recycling development process waste liquid according to the present embodiment, waste liquid formed from developer liquid and development replenisher liquid discharged from an automatic developing machine 10 during the plate-making process for the photosensitive planographic printing plate precursor, is stored in an intermediate tank 20. Waste liquid delivered from the intermediate tank 20 is heated without pressure reduction, or heated under reduced pressure, using a waste liquid concentration device 30 provided with an evaporation-concentration means, whereby evaporated water content (water vapor) is separated from residual concentrates (a slurry). The water content separated as water vapor is condensed by cooling, to generate regenerated water, and the regenerated water thus generated is introduced to a regenerated water tank 50. Waste liquid concentrated in the waste liquid concentration device 30 is recovered in a waste liquid recovery tank 40. The transfer of concentrated waste liquid to the waste liquid recovery tank 40 is preferably performed by applying pressure using a pump.

In this system in the invention, as described above, the concentration, by evaporation, of the plate-making process waste liquid generated during a plate-making process for a photosensitive planographic printing plate precursor, and the generation of regenerated water are performed efficiently, and the occurrence of contamination in the waste liquid concentration device is suppressed, by using a development replenisher liquid that includes at least one surfactant selected from the group consisting of anionic surfactants having a naphthalene skeleton and nonionic surfactants having a naphthalene skeleton at a total content of from 1% by mass to 10% by mass, that includes no organic solvent having a boiling point within a range of from 100°C to 300°C or includes organic solvent having a boiling point within a range of from 100°C to 300°C at a total content of no more than 2% by mass, and that has a pH of from 10 to 13, and also adjusting the concentration ratio of the waste liquid to be within the above range..

The waste liquid concentration device 30 provided with an concentration device for concentrating waste liquid, includes at least: an evaporation pot (not illustrated in the drawings) in which waste liquid delivered from the intermediate tank 20 is heated without pressure reduction, or heated under reduced pressure, and in which the evaporated water content and the residual concentrates (the slurry) are separated; and a cooling pot (not illustrated in the drawings) to which the water content separated as water vapor (which may include an organic solvent) in the evaporation pot is introduced, and condensed by cooling to yield regenerated water.

Preferably, a heat pump unit that transports heat between the interior of the evaporation pot and the interior of the cooling pot is provided. Namely, it is preferable that a heat pump is employed as a heating means of the evaporation pot and as a cooling means of the cooling pot, such that the plate-making process waste liquid is heated by the heat release section of the heat pump, and the heat absorption section of the heat pump functions as a cooling means of the cooling pot, and cools the water vapor.

The concentration of the waste liquid is preferably performed using a method including concentrating, by heating, the waste liquid while the pressure inside the evaporation pot is reduced using a pressure reduction means, since this method enables a decrease in the boiling point of the waste liquid, and concentration of the waste liquid by evaporation at a temperature lower than that under atmospheric pressure. Use of a pressure reduction means has advantages including higher safety and lower vulnerability of the evaporation pot, waste liquid, and waste liquid concentrate to heat. Examples of the pressure reduction means include general a mechanical vacuum pump of a water sealed type, an oil-sealed rotary type, a diaphragm type, or the like, a diffuser pump using oil or mercury, a compressor such as a multistage turbo compressor, a reciprocating compressor, or a screw compressor, and an aspirator. Of these, an aspirator is preferably used in view of maintainability and cost. The reduced pressure conditions may be, for example, a pressure reduction to 13332.2 Pa (100 mmHg) or less, and preferably to 3999.66 Pa (30 mmHg) or less.

Use of a heat pump as a heating means of the evaporation pot, and as a cooling means of the cooling pot, is also a preferable mode. In this mode, it is possible to heat the plate-making process waste liquid at the heat release section of the heat pump, and to cool the water vapor at the heat absorption section of the heat pump. Since concentration of waste liquid by heating is performed using heat released from the heat pump and condensation of the water vapor is performed by heat adsorption by the heat pump, high thermal efficiency can be achieved, and benefits are obtained such as prevention of occurrence of local high temperatures, provision of higher safety, and reduction of carbon dioxide emissions, compared to cases in which a heating means of an electrical heater or the like is used.

As the heating conditions, a temperature range suitable for a pressure of from 666.61 Pa (5 mmHg) to 13332.2 (100 mmHg), which is a pressure easily obtainable using a water flow pump or a vacuum pump, is selected. Specifically, the temperature range may be a range of from 20°C to 80°C, and more preferably a range of from 25°C to 45°C.

Concentration involving distillation at high temperature requires a large amount of electrical power. Therefore, the heating temperature may be lowered by reducing pressure, to suppress the amount of electrical power used.

In the waste liquid concentration device 30, in the process of concentrating the plate-making process waste liquid by evaporation, the plate-making process waste liquid is heated by the heating means in the evaporation pot, thereby being evaporated and concentrated to a ratio of from 1/10 to 1/2 on a volume basis. When the concentration ratio is 1/(less than 2), the amount of waste liquid to be processed is not reduced efficiently. In cases in which concentration is performed to a concentration ratio of 1/(10 or more), there is a higher tendency that precipitation of solids formed from the waste liquid concentrated within the evaporation pot of the waste liquid concentration device 30 occurs, and the maintainability may deteriorate.

Commercially available waste liquid concentration devices include heat pump type devices XR-2000 and XR-5000 (trade names) manufactured by Takagi Refrigerating Co., Ltd., and heating-type FRIENDLY series (trade name) devices manufactured by Cosmotec Co., Ltd.

The regenerated water tank 50 that temporarily stores separated regenerated water, and a distillatively-regenerated water reutilization device 60 that regulates the supply of regenerated water to the automatic developing machine 10, are provided. The distillatively-regenerated water reutilization device 60 is preferably provided with: a replenishment water tank 80 that supplies regenerated water to the automatic developing machine 10; piping that connects the replenishment water tank 80 to a development bath of the automatic developing machine 10; a pressure gauge that measures the pressure inside the piping; and a pump. Further, a means may be provided which includes an analytical device, analyzes the components of the regenerated water, and controls the composition of regenerated water by performing neutralization, supply of fresh water, or the like in accordance with the components.

The recovered regenerated water is supplied to the automatic developing machine 10 from the replenishment water tank 80 by controlling the driving of the pump in accordance with the pressure value measured by the pressure gauge provided to the distillatively-regenerated water reutilization device 60. Development replenisher liquid is supplied to the automatic developing machine 10 from a development replenisher liquid tank 70.

Regenerated water obtained in this system may include an organic solvent as long as the total content of organic solvent is 5% by volume or less.

The obtained regenerated water has a low biological oxygen demand (BOD value) and a low chemical oxygen demand (COD value). In cases in which the development replenisher liquid for use in the invention is used, a BOD value of 250 mg/L or less and a COD value of 200 mg/L or less are obtained. Therefore, in addition to using regenerated water as diluent water for the preparation of the development replenisher liquid for the automatic developing machine, or as rinse water, surplus regenerated water may also be discharged as it is to general sewage. However, in cases in which the regenerated water includes an organic solvent or the like, treatment with activated sludge or the like is performed before the discharge.

The composition and pH of the development replenisher liquid stipulated in the invention refer to the composition and pH of the development replenisher liquid at the time of it is being used in development in the automatic developing machine.

In the present embodiment, the supply of the development replenisher liquid to the development bath of the automatic developing machine 10 may be carried out by supplying development replenisher liquid, as it is, that has the development replenisher liquid composition and pH as specified in the invention, or supplying development replenisher liquid that has been obtained by diluting concentrate liquid for the preparation of development replenisher liquid so as to have the composition and pH as specified in the invention. In cases in which the concentrate liquid for the preparation of development replenisher liquid is diluted, a mode may be adopted in which, as in the system illustrated in Fig. 1, the amount of regenerated water supplied from the replenishment water tank 80 is controlled in accordance with the amount of concentrate liquid for the preparation of development replenisher liquid supplied from the development replenisher liquid tank 70 such that the concentrate liquid for the preparation of development replenisher liquid is diluted at a specific ratio in the development bath, which is not illustrated in the drawings, disposed in the automatic developing machine 10. Alternatively, development replenisher liquid, which has been obtained by mixing concentrate liquid for the preparation of development replenisher liquid and regenerated water in advance so as to dilute the concentrate liquid at a ratio satisfying the predetermined composition and pH conditions, may be supplied to the development bath. Namely, in the invention, there are no particular limitations to the manner in which the concentrate liquid for the preparation of development replenisher liquid is diluted.

Plate-making process waste liquid generated from plural automatic developing machines may be collected together and processed in a single waste liquid concentration device 30. The obtained regenerated water may be supplied as diluent water or rinse water to plural automatic developing machines.

### Developer Liquid

Explanation follows regarding developer liquid suitably employed for development of a photosensitive planographic printing plate precursor after the photosensitive planographic printing plate precursor has been exposed to light, in the method of recycling plate-making process waste liquid according to the invention.

In the present specification, unless otherwise stated, the term "developer liquid" has a meaning that encompasses development initiation liquid (a narrow definition of developer liquid) as well as development replenisher liquid.

The developer liquid and development replenisher liquid to which the invention may be applied may be negative-working developer liquids for development of a photosensitive planographic printing plate precursor having a radical-polymerizable image recording layer. The developer liquid is described in more detail below.

In the present specification, negative-working developer liquid refers to a developer liquid used in development of a photosensitive planographic printing plate precursor having a negative-working image recording layer after the photosensitive planographic printing plate has been exposed to light.

The development replenisher liquid used in the invention includes at least one surfactant selected from the group consisting of anionic surfactants having a naphthalene skeleton and nonionic surfactants having a naphthalene skeleton at a total content of from 1% by mass to 10% by mass, and the development replenisher liquid includes no organic solvent having a boiling point within a range of from 100°C to 300°C or includes organic solvent having a boiling point within a range of from 100°C to 300°C at a total content of no more than 2% by mass, and the development replenisher liquid has a pH of from 10 to 13.

Usually, in cases in which plate-making processes are performed continuously in an automatic developing machine, in the development bath after a certain amount of plates have been processed, the development initiation liquid has been replaced by the development replenisher liquid added. In the invention, the composition and pH of at least the development replenisher liquid to be used meet the conditions stipulated in the invention. It is preferable that both the developer liquid, including the development initiation liquid, and the development replenisher liquid at the time of use in the development process has the composition and pH as specified in the invention.

The plate-making process waste liquid in the invention is concentrated at a degree of concentration within a range of from 1/10 to 1/2 (= plate-making process waste liquid after concentrating/plate-making process waste liquid before concentrating) on a volume basis, and concentrating at a degree of concentration within a range of from 1/8 to 1/3 is preferable. When the degree of concentration is within this range, contamination of the concentration pot is suppressed, and continuous operation over a long period of time is possible. The regenerated water obtained can be reutilized, and the amount of waste liquid discarded as plate-making process waste liquid is extremely small. In the invention, the degree of concentration refers to a fraction, on a volume basis, with the total amount of plate-making process waste liquid before concentration as the denominator, and the total amount of plate-making process waste liquid after concentration as the numerator, expressed with the plate-making process waste liquid after concentration standardized to one.

Regenerated water stored in the regenerated water tank 50 is delivered to the replenishment water tank 80 through the distillatively-regenerated water reutilization device 60. The concentrate liquid of the development replenisher liquid is delivered from the development replenisher liquid tank 70 to the automatic developing machine 10, as appropriate.

Specific examples of apparatuses related to methods of recycling plate-making process waste liquid, which can suitably be used in the invention, include the planographic printing plate-making process waste liquid curtailment apparatus described in Japanese Patent No. 4774124, and the waste liquid processing apparatus described in JP-A No. 2011-90282.

The developer liquid used for a photosensitive planographic printing plate precursor having a radical-polymerizable image recording layer in the invention may be a negative-working developer liquid.

In the developer liquid according to the invention, the total content of anionic or nonionic surfactant having a naphthalene skeleton is from 1% by mass to 10% by mass, and the total content of organic solvent having a boiling point within a range of from 100°C to 300°C is no more than 2% by mass. The developer liquid has a pH of from 10 to 13.

### Negative-Working Developer Liquid

The negative-working developer liquid used in development of the planographic printing plate precursor according to the invention is preferably an alkali developer liquid which includes at least the surfactant described above and an alkali metal hydroxide, and in which the total content of the organic solvent described above is no more than 2% by mass, and which does not include a silicate component, and which has a pH of from 10 to 12.5.

### Surfactant

The surfactant included in the negative-working developer liquid in the invention is an anionic surfactant having a naphthalene skeleton or a nonionic surfactant having a naphthalene skeleton.

The anionic surfactant for use in the negative-working developer liquid is preferably a sulfonic acid salt having a naphthalene skeleton or a sulfuric acid salt having a naphthalene skeleton, and more preferably at least one selected from the group consisting of naphthalene sulfonic acid salts that may have a substituent and the compounds represented by Formula (A) below.

In the naphthalene sulfonic acid salts that may have a substituent, the substituent is preferably an alkyl group having from 1 to 20 carbon atoms. It is preferable that the naphthalene ring is substituted by from 1 to 4 alkyl groups each having from 1 to 20 carbon atoms, and it is more preferable that the naphthalene ring is substituted by from 1 to 2 alkyl groups each having from 1 to 20 carbon atoms. It is preferable that the naphthalene ring is substituted by from 1 to 3 sulfonic acid salt groups, and it is more preferable that the naphthalene ring is substituted by from 1 to 2 sulfonic acid salt groups. Preferable examples of the salt include a sodium salt, a potassium salt, and an ammonium salt.

Specific examples thereof include sodium di(t-butyl)naphthalene sulfonate, sodium mono(t-butyl) naphthalene sulfonate, sodium di(t-butyl) naphthalene disulfonate, sodium mono(t-butyl) naphthalene disulfonate, and mixtures thereof.

The anionic surfactant having a naphthalene skeleton is preferably an anionic surfactant represented by the following Formula (A).

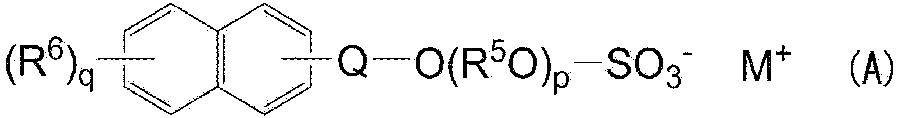

In Formula (A), R⁵ represents a straight-chain or branched-chain alkylene group having from 1 to 5 carbon atoms; R⁶ represents a straight-chain or branched chain alkyl having from 1 to 20 carbon atoms; q represents 0, 1, or 2; Q represents a single bond or an alkylene group having from 1 to 10 carbons; and p represents an integer from 1 to 100. When p or q is 2 or greater, each R⁶, or R⁵, may be the same group as each other, or may be selected from two or more types of groups. M⁺ represents Na⁺, K⁺, Li⁺ or NH₄⁺.

In a preferable embodiment of the invention, R⁵ in Formula (A) is preferably, for example, -CH₂-, -CH₂-CH₂-, -CH₂-CH₂-CH₂, or -CH₂CH(CH₃)-, and more preferably -CH₂CH₂-. R⁶ is preferably, for example, CH₃, C₂H₅, C₃H₇, or C₄H₉· Further, q is preferably 0 or 1. Q is preferably a single bond. Further, p is preferably an integer from 1 to 20.

Specific examples of compounds represented by Formula (A) include the following compounds.

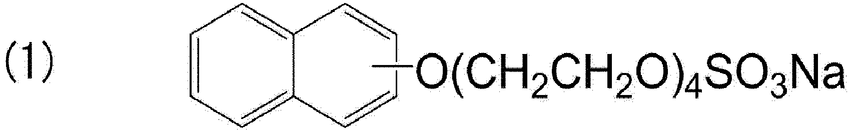

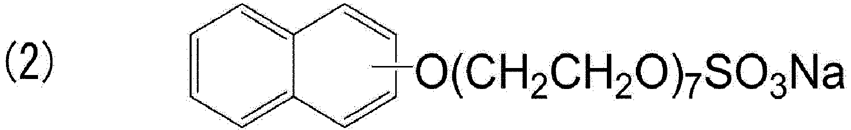

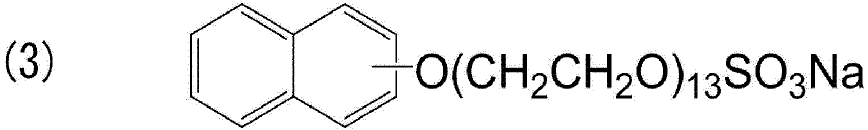

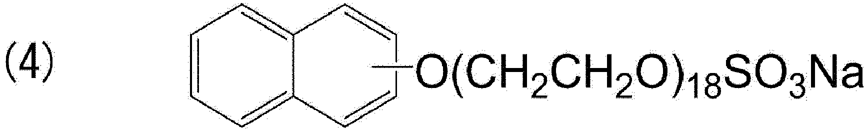

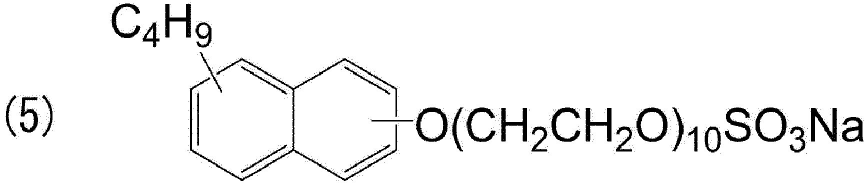

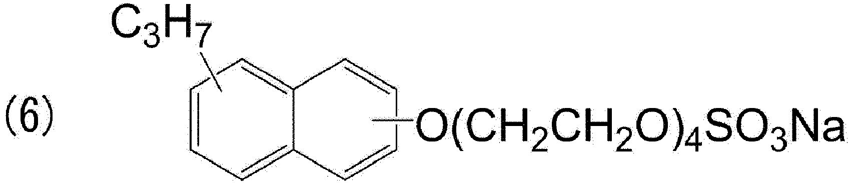

The nonionic surfactant having a naphthalene skeleton is preferably a surfactant represented by the following Formula (B).

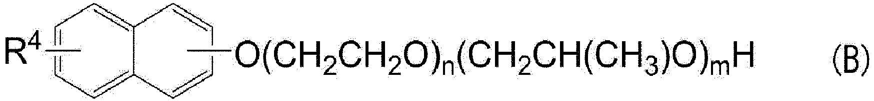

In Formula (B), R⁴ represents a hydrogen atom, or an alkyl group having from 1 to 100 carbon atoms; and each of n and m independently represents an integer from 0 to 100, provided that n and m are not simultaneously 0.

Preferable examples of the compound represented by Formula (B) include polyoxyethylene naphthyl ether, polyoxyethylene methyl naphthyl ether, polyoxyethylene octyl naphthyl ether, and polyoxyethylene nonyl naphthyl ether.

In the compound represented by Formula (B) above, the number of repeating units in the polyoxyethylene chain is preferably from 3 to 50, and more preferably from 5 to 30. Each of the polyoxyethylene portion and the polyoxypropylene portion may be a random or block copolymer. When the number of repeating units in the polyoxyethylene chain is from 3 to 50, the number of repeating units in the polyoxypropylene chain is preferably from 1 to 10. In cases in which only the polyoxypropylene chain is included, m is preferably from 1 to 10.

The nonionic surfactant represented by Formula (B) may be used singly, or in combination of two or more thereof.

Specific examples of the compound represented by Formula (B) include those illustrated below.

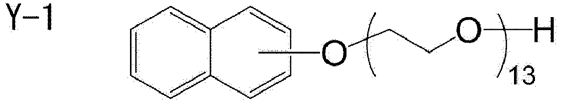

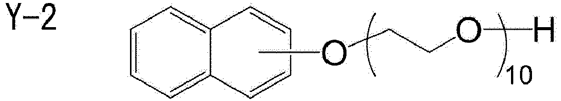

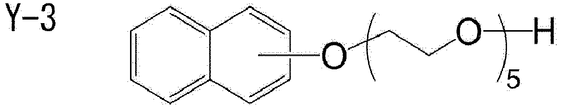

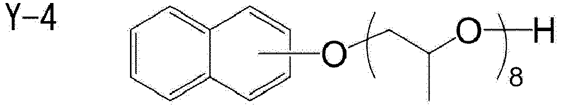

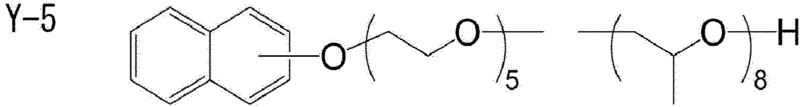

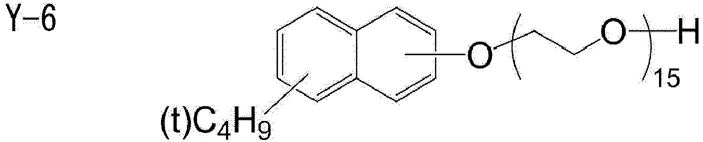

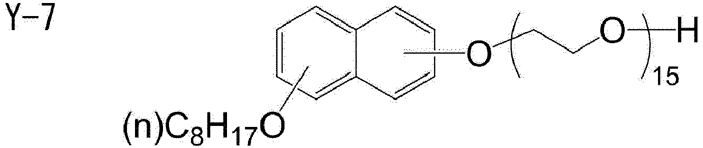

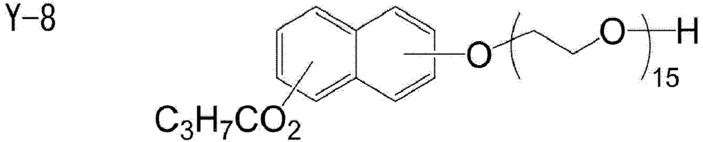

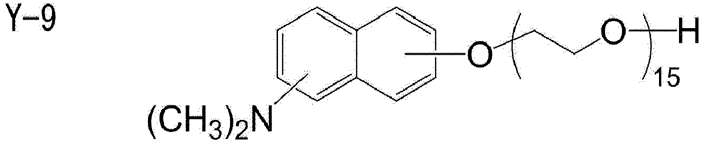

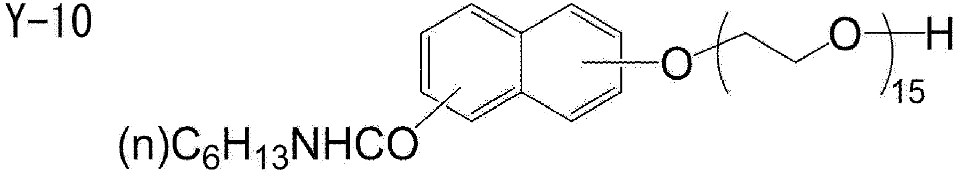

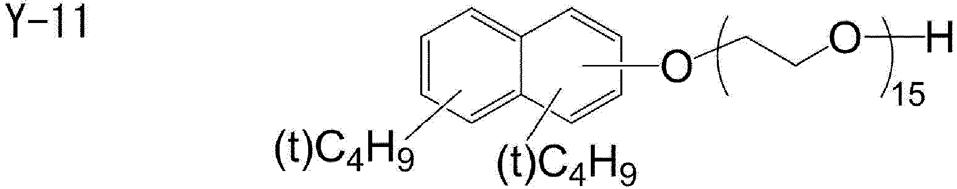

These surfactants may be used singly or in combination of two or more thereof.

The content of the surfactant in the developer liquid, in terms of active ingredient, is in a range of from 1% by mass to 10% by mass, and is preferably in a range of from 2% by mass to 10% by mass. When the content is 1% by mass or greater, the developability and the solubility of image recording layer components at regions that have not been exposed to light are excellent. When the content is 10% by mass or less, excellent printing durability of the printing plate is obtained.

The above descriptions of the content of the surfactant also apply to the content of the surfactant in the development replenisher liquid.

### Organic Solvent

In the invention, in the developer liquid (including the development replenisher liquid) used in the development of the photosensitive planographic printing plate precursor, the content of organic solvent having a boiling point within a range of from 100°C to 300°C is in a range of no more than 2% by mass, and there may be cases in which this type of organic solvent is not included.

When the boiling point of an organic solvent included in the developer liquid is lower than 100°C, the organic solvent easily evaporate. When the boiling point of an organic solvent included in the developer liquid is above 300°C, concentration becomes difficult; therefore, a boiling point of higher than 300°C is not desirable.

The organic solvent included in the developer liquid may be any type of organic solvent having a boiling point within a range of from 100°C to 300°C. The organic solvent is preferably 2-phenylethanol (boiling point: 219°C), 3-phenyl-1-propanol (boiling point: 238°C), 2-phenoxyethanol (boiling point: from 244 to 255°C), benzylalcohol (boiling point: 205°C), cyclohexanol (boiling point: 161°C), monoethanolamine (boiling point: 170°C), diethanolamine (boiling point: 268°C), cyclohexanone (boiling point: 155°C), ethyl lactate (boiling point: 155°C), propylene glycol (boiling point: 187°C), ethylene glycol (boiling point: 198°C), γ-butyrolactone (boiling point: 205°C), N-methylpyrrolidone (boiling point: 202°C), N-ethylpyrrolidone (boiling point: 218°C), glycerin (boiling point: 290°C), propylene glycol monomethyl ether (boiling point: 120°C), ethylene glycol monomethyl ether (boiling point: 124°C), ethylene glycol monomethyl ether acetate (boiling point: 145°C), diethylene glycol dimethyl ether (boiling point: 162°C), or glycerin (boiling point: 299°C), and particularly preferably benzylalcohol, diethanolamine, monoethanolamine, γ-butyrolactone, N-methylpyrrolidone, or N-ethylpyrrolidone.

The amines of alkali agents described below are also included in the scope of the organic solvent in the invention when the alkali amines have boiling points within a range of from 100°C to 300°C.

### Other Components That Can Be Used in the Developer Liquid

### Organic Acid or Salt Thereof

The developer liquid according to the invention has a pH of from 10 to 13. The pH of the developer liquid may be adjusted using a pH adjuster. The developer liquid preferably includes, as a pH adjuster, an organic carboxylic acid such as citric acid, malic acid, tartaric acid, benzoic acid, phthalic acid, p-ethyl benzoic acid, p-n-propyl benzoic acid, p-isopropyl benzoic acid, p-n-butyl benzoic acid, p-t-butyl benzoic acid, p-t-butyl benzoic acid, p-2-hydroxyethyl benzoic acid, decanoic acid, salicylic acid, or 3-hydroxy-2-naphthoic acid, or a metal salt or ammonium salt thereof, or the like. Of these acids, citric acid functions as a buffer and is added, for example, in the form of trisodium citrate or tripotassium citrate. Generally, the acid is included in the developer liquid preferably within a range of from 0.05% by mass to 5% by mass, and more preferably from 0.3% by mass to 3% by mass.

### Chelating Agent

A chelating agent for a bivalent metal may be included in the developer liquid. Examples of bivalent metals include magnesium and calcium. Examples of chelating agents for bivalent metals include: polyphosphates such as Na₂P₂O₇, Na₅P₃O₃, Na₃P₃O₉, Na₂O₄P(NaO₃P)PO₃Na₂, and calgon (sodium polymetaphosphate); amino polycarboxylic acids such as ethylene diamine tetraacetic acid or a potassium salt or sodium salt thereof, diethylene triamine pentaacetic acid or a potassium salt or sodium salt thereof, triethylene tetramine hexaacetic acid or a potassium salt or sodium salt thereof, hydroxyethyl ethylene diamine triacetic acid or a potassium salt or sodium salt thereof, nitrilotriacetic acid or a potassium salt or sodium salt thereof, 1,2-diaminocyclohexane tetraacetic acid or a potassium salt or sodium salt thereof, and 1,3-diamino-2-propanol tetraacetic acid or a potassium salt or sodium salt thereof; and organic phosphonic acids, such as 2-phosphonobutane 1,2,4-tricarboxylic acid or a potassium salt or sodium salt thereof, 2-phosphonobutanone 2,3,4-tricarboxylic acid or a potassium salt or sodium salt thereof, 1-phosphonoethane 1,2,2-tricarboxylic acid or a potassium salt or sodium salt thereof, 1-hydroxy ethane-1,1-diphosphonic acid or a potassium salt or sodium salt thereof, and amino tri(methylene phosphonic acid) or a potassium salt or sodium salt thereof.

The content of chelating agent, such as those described above, included in the developer liquid varies with the hardness and usage amount of hard water used in the developer liquid. Generally, the chelating agent may be included in the developer liquid within a range of from 0.01% by mass to 5% by mass, and more preferably from 0.01% by mass to 0.5% by mass.

### Antifoaming Agent

Inclusion of an anionic surfactant in the developer liquid may increase the tendency toward foaming. Therefore, an antifoaming agent may also be added to the developer liquid. In cases in which an antifoaming agent is added, the antifoaming agent is preferably added at from 0.00001% by mass or more with respect to the developer liquid, and more preferably added at from approximately 0.0001% by mass to approximately 0.5% by mass with respect to the developer liquid.

Examples of antifoaming agents that can be used in the developer liquid according to the invention include a fluorine-containing antifoaming agent, a silicone-containing antifoaming agent, acetylene alcohol, and acetylene glycol.

Examples of the fluorine-containing antifoaming agent include the compounds represented by the following Formula.

Of these compounds, fluorine antifoaming agents having a HLB of from 1 to 9, particularly fluorine antifoaming agents having a HLB of from 1 to 4, are preferably used. The fluorine-containing antifoaming agent may be added to the developer liquid as it is, or added in the form of an emulsion liquid obtained by mixing the fluorine-containing antifoaming agent with water, another solvent or the like.

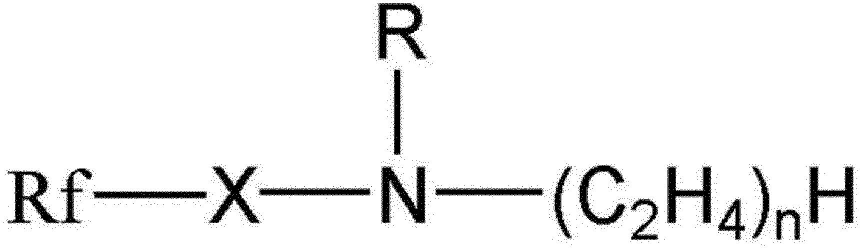

In the formula, R represents a hydrogen atom or an alkyl group; Rf represents a fluorocarbon group (having approximately from 5 to 10 carbon atoms) obtained by replacing some or all of the hydrogen atoms of an alkyl group by a fluorine atom or fluorine atoms; X represents CO or SO₂; and n represents an integer of from 1 to 10.

Silicone-containing antifoaming agents that may be used include a dialkyl polydioxane, preferably dimethyl polydioxane shown below, itself or an O/W emulsion liquid thereof, 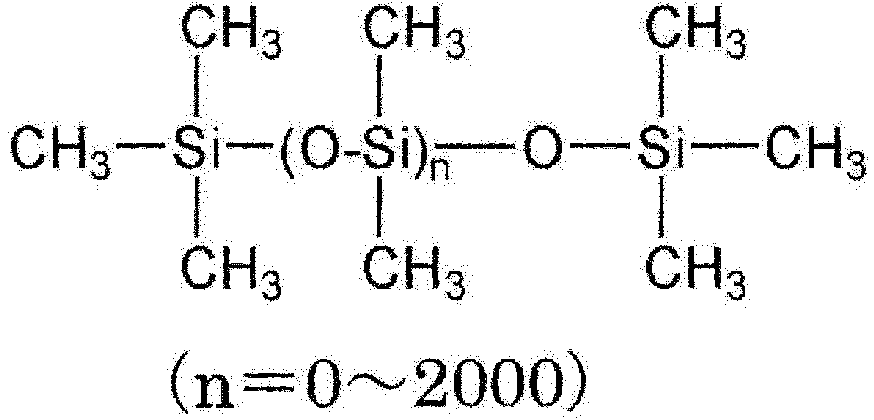 the alkoxypoly(ethyleneoxy)siloxane shown below, 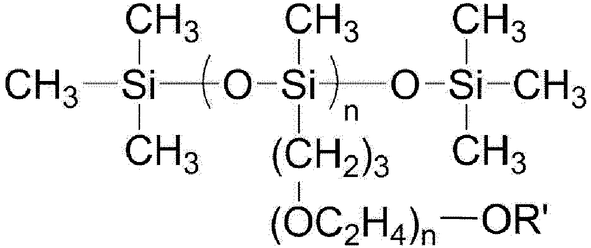 (n: from 6 to 10, R': an alkyl group having from 1 to 4 carbon atoms) 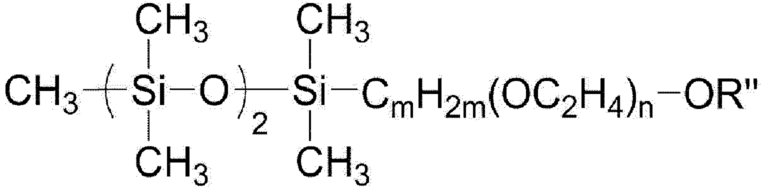 (m: from 2 to 4, n: from 4 to 12, R": an alkyl group having from 1 to 4 carbon atoms)

and a product obtained by modifying dimethyl polydioxane by partial introduction of carboxylic acid groups or sulfonic acid groups, or an emulsion liquid obtained by mixing any of these silicone-containing compounds with water together with a generally known anionic surfactant.

The acetylene alcohol is an unsaturated alcohol having an acetylene bond (triple bond) in a molecule thereof. Acetylene glycol is an unsaturated glycol having an acetylene bond (triple bond) in a molecule thereof, and is also known as alkynediol.

More specific examples include compounds represented by Formulas (1) and (2) below.

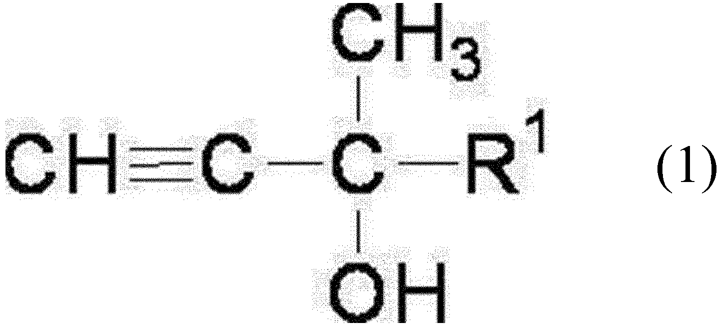

In Formula (1), R¹ represents a straight-chain or branched-chain alkyl group having from 1 to 5 carbon atoms.

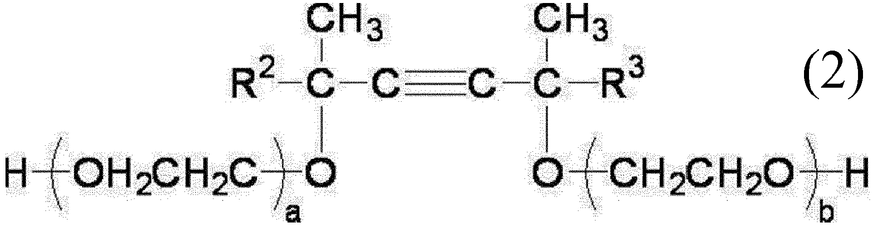

In Formula (2), each of R² and R³ independently represents a straight-chain or branched-chain alkyl group having from 1 to 5 carbon atoms; each of a and b independently represents an integer value of 0 or greater; and a + b is a number of from 0 to 30.

In Formula (2), examples of the straight-chain or branched-chain alkyl group having from 1 to 5 carbon atoms include a methyl group, an ethyl group, an isopropyl group, an isobutyl group, and an isopentyl group.

Further specific examples of the acetylene alcohol and the acetylene glycol include those listed below.
(1) propargyl alcohol
(2) propargyl carbinol
(3) 3,5-dimethyl-1-hexyne-3-ol
(4) 3-methyl-1-butyne-3-ol
(5) 3-methyl-1-pentyne-3-ol
(6) 1,4-butyne diol
(7) 2,5-dimethyl-3-hexyne-2,5-diol
(8) 3,6-dimethyl-4-octyne-3,6-diol
(9) 2,4,7,9-tetramethyl-5-decyne-4,7-diol
(10) adduct of 2,4,7,9-tetramethyl-5-decyne-4,7-diol and ethylene oxide (the structure of which is shown below) 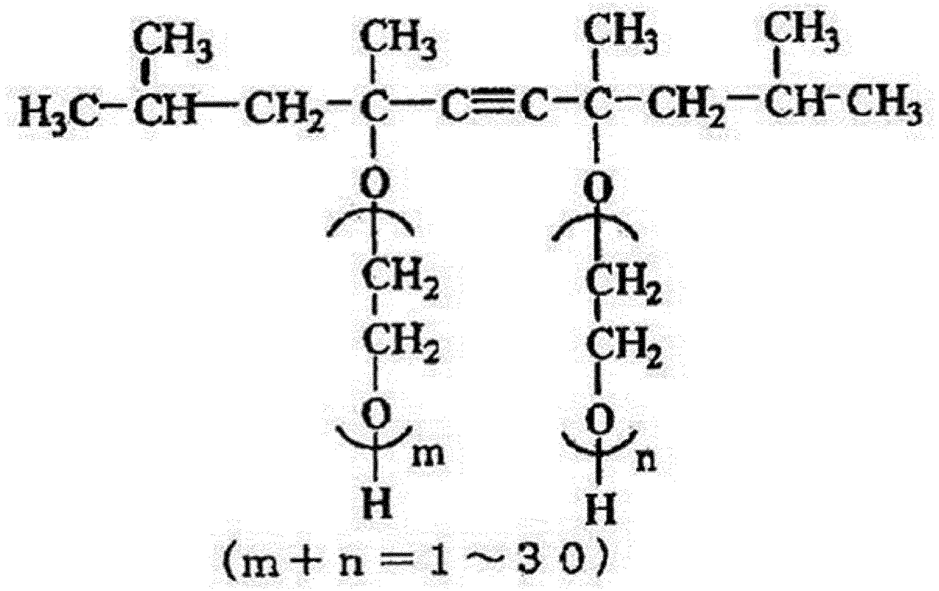
(11) 2,5,8,11-tetramethyl-6-dodecyne-5,8-diol

These acetylene alcohols and acetylene glycols are commercially available, and known examples of commercially available products include products under the trade name SURFYNOL Series by Air Products and Chemicals Inc., and products under the trade name OLFINE Series by Nissin Chemical Industry Co., Ltd. Specific examples of commercially available products include SURFYNOL 61, which is the compound (3) above, OLFINE B, which is the compound (4) above, OLFINE P, which is the compound (5) above, OLFINE Y, which is the compound (7) above, SURFYNOL 82, which is the compound (8) above, SURFYNOL 104, which is the compound (9) above, OLFINE AK-02, SURFYNOL 400 series, which is the compound (10) above, and SURFYNOL DF-110, which is the compound (11) above (all trade names).

### Development Adjuster

An alkali metal salt of an organic acid, or an alkali metal salt of an inorganic acid, may be added to the negative-working developer liquid as a development adjuster. For example, sodium carbonate, potassium carbonate, ammonium carbonate, sodium citrate, potassium citrate, ammonium citrate, or the like may be used singly, or in mixture consisting of a combination of two or more thereof.

### Alkali Agent

The negative-working developer liquid may include, as an alkali agent, one of, or a mixture consisting of a combination of two or more of: inorganic alkalis such as trisodium phosphate, tripotassium phosphate, triammonium phosphate, sodium borate, potassium borate, ammonium borate, sodium hydroxide, potassium hydroxide, ammonium hydroxide, and lithium hydroxide, and organic alkalis such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethyl ammonium hydroxide.

In the negative-working developer liquid, in addition to the components described above, components such as the following components may also be used. Examples include chelating agents, reducing agents, dyes, pigments, water softeners, and preservatives.

The pH of the developer liquid should be from 10 to 13, and is preferably from 11 to 12.5. The electrical conductivity, x, of the developer liquid preferably satisfies 2 mS/cm < x < 30 mS/cm, and the electrical conductivity of the developer is more preferably from 5 mS/cm to 25 mS/cm.

An alkali metal salt of an organic acid or an alkali metal salt of an inorganic acid may be added, as an electrical conductivity adjusting agent, to adjust the electrical conductivity.

### Water

The remaining component of the negative-working developer liquid described above is water. From the viewpoint of transportation, it is advantageous that the developer liquid (concentrate developer liquid) according to the invention is prepared as a concentrate liquid having a lower content of water than that at the time of use, and is diluted with water at the time of use. In this case, it is appropriate for the degree of concentration to be a level at which separation or precipitation of the components does not occur.

The developer liquid according to the invention may include a silicate component. However, the content of silicate component in the developer liquid is preferably 1% by mass or less, and more preferably 0.5% by mass or less. It is still more preferable that the developer liquid does not include a silicate component. A content of silicate component exceeding 1% by mass is not preferable as this level of silicate component content facilitates solid adhesion of the silicate component in the plate-making process waste liquid concentration device, which may lead to a decrease in concentration efficiency or occurrence of discharge problems due to the solid adhesion of the silicate component to the interior of the waste liquid concentration device after concentration.

The silicate component is a compound that includes an anion having a structure in which electronegative ligands surround one or plural silicon atoms at the center, and is a compound that includes a chemical species such as a silicate, in which oxygen atoms are ligands, or hexafluorosilicate [SiF₆]²⁻.

### Development Replenisher Liquid

As stated above, in the present specification, the meaning of "developer liquid" also encompasses "development replenisher liquid".

In the present specification, "development initiation liquid" means developer liquid present in the development bath before the plate-making processes are performed, unless otherwise stated. The term "development replenisher liquid" means development replenisher liquid that is to be supplied to developer liquid in the development bath that has deteriorated due to the development process for planographic printing plate precursors, absorption of carbon dioxide, and the like.

The characteristics of the development replenisher liquid according to the invention are explained below.

The development replenisher liquid should have the composition and pH as stipulated in the invention when used in the development process; provided these conditions are met, the development replenisher liquid may have a higher activity level than that of the development initiation liquid in order to restore the activity level of developer liquid that has deteriorated.

Various surfactants, besides the surfactants described above, and organic solvents may be added to the developer liquid (including the development replenisher liquid) if necessary, for the purpose of promoting or suppressing the developing power, and raising the diffusivity of development residues and the ink affinity of the printing plate image portions. Reducing agents such as hydroquinone, resorcinol, and a sodium or potassium salt of an inorganic acid such as sulfurous acid or hydrogen sulfite, organic carboxylic acids, and water softeners may be added to the developer liquid, if necessary.

The development initiation liquid initially fed into the development bath of the automatic developing machine 10 is deteriorated by eluted materials generated by the processing of planographic printing plate precursors. Since the developer liquid has alkalinity, its pH is lowered by the absorption of atmospheric carbon dioxide, and the developer liquid deteriorates. Accordingly, in order to perform development continuously for long periods of time in the automatic developing machine 10, the development replenisher liquid that compensates for the deterioration should replenish the developer liquid at intervals or continuously, in order to maintain the development quality of planographic printing plate precursors.

Methods for introducing the development replenisher liquid to the development bath of the automatic developing machine include: (1) a method in which a concentrate liquid for the preparation of development replenisher liquid and water are each separately introduced to the development bath at a specific ratio, the development replenisher liquid having higher activity than that of the initially-employed developer liquid; (2) a method in which a concentrate liquid for the preparation of development replenisher liquid is pre-mixed with, and diluted by, water at a specific ratio, and subsequently introduced to the development bath, the development replenisher liquid having higher activity than that of the initially-employed development initiation liquid; and (3) a method in which a development replenisher liquid prepared to originally have a specific concentration is introduced to the development bath as it is. In any of these cases, the development replenisher liquid should have the composition and pH as stipulated in the invention when it is employed in development.

Conventionally, in methods (1) and (2), a small amount of a development replenisher liquid that is as concentrated (as high activity) as possible is added in order to reduce the amount of waste liquid generated. However, when a high activity liquid is employed as the development replenisher liquid, since the salt concentration in the developer liquid in the development bath becomes high, there is a possibility that eluted materials generated during development is more likely to precipitate, and, since the concentration of the eluted materials generated during development is high, there is a possibility that the eluted materials are more likely to precipitate.

Further, precise control is necessary for additions of small volume.

In conventional methods, increasing the addition amount of development replenisher liquid results in a corresponding increase in the amount of waste liquid, with the issue of an increase in plate-making process waste liquid to be processed. According to the recycling method according to the invention, development activity is the same or greater than that of the initially-employed developer liquid. By introducing concentrate liquid for the preparation of development replenisher liquid + regenerated water to the development bath at a lower overall concentration than a standard concentration (, which is the standard overall concentration of the concentrate liquid for the preparation of development replenisher liquid + water in the case of employing method (1) or (2), or the standard concentration of the undiluted development replenisher liquid when employing method (3)), at an addition amount greater than the standard replenishment amount in order to obtain the same activity, eluted materials generated due to development is less likely to precipitate. Generally, in cases in which a large amount of development replenisher liquid having a low concentration is added in an attempt to maintain a constant activity, the concentrations of salts originating from developer liquid in the development bath are suppressed to a low level, and the concentration of eluted materials generated due to development is low, as a result of which high quality development can be continued while suppressing generation of precipitates; however, the amount of development process waste liquid is also large. In contrast, in the method according to the invention, regenerated water separated from development process waste liquid is supplied to the automatic developing machine 10, and reutilized, as a result of which the amount of development process waste liquid discharged out of the system relative to the amount of development replenisher liquid supplied can be remarkably reduced in comparison with conventional methods.

In cases in which development is performed using an automatic developing machine, it is possible to add a development replenisher liquid having greater alkalinity than that of the development initiation liquid to the developer liquid without diluting, whereby planographic printing plate precursors can be processed for an even longer time without replacing the developer liquid in the development tank. It is also preferable that the alkalinity (amount of alkali agent added per unit volume) of the development replenisher liquid is set to be from 2 to 20 times the alkalinity of the development initiation liquid.

### Photosensitive Planographic Printing Plate Precursor

Detailed explanation follows regarding a photosensitive planographic printing plate precursor preferably applied to the method of recycling plate-making process waste liquid according to the invention.

### Negative-Working Photosensitive Planographic Printing Plate Precursor

In the method of recycling plate-making process waste liquid according to the invention, a particularly notable effect can be obtained by using the negative-working photosensitive planographic printing plate precursor described in detail below. Therefore, the use of the negative-working photosensitive planographic printing plate precursor described below is preferable.

Namely, examples of a photosensitive composition used for the formation of a photosensitive image recording layer in a preferable planographic printing plate precursor to be processed in the method of recycling plate-making process waste liquid according to the invention include a heat-polymerization or thermal-polymerization photosensitive composition that includes an infrared absorbent, a polymerization initiator, a monomer including an ethylenic unsaturated bond, and a binder polymer, and a photopolymerization photosensitive composition that includes a photopolymerization initiator, a photopolymerizable composition, and a binder polymer.

Description is given below regarding the photopolymerization photosensitive composition.

### Photopolymerization Photosensitive Composition

A photopolymerization photosensitive composition, serving as an example of a photosensitive composition for forming an image recording layer on a planographic printing plate precursor that is to be processed in the method of recycling plate-making process waste liquid according to the invention, includes a photopolymerization initiation system that is sensitive to light within a wavelength region of from visible light to ultraviolet light, a polymerizable compound having at least one ethylenically unsaturated group, and a binder polymer.

The photosensitive composition may be applied to a support, such as an aluminum plate, to form a photosensitive layer (image recording layer), and the resultant can be used as a photosensitive planographic printing plate precursor. The photosensitive planographic printing plate precursor of this type has a structure in which a photosensitive layer and, optionally, a protective layer are layered in this order on the support on which an undercoat layer has been provided if desired. Here, the expression "layered in this order" means that the undercoat layer, the photosensitive layer, and the protective layer are provided, in this order, on the support. The undercoat layer and the protective layer are layers that are provided if necessary. Other layers, such as an intermediate layer or a backcoat layer, may be provided in accordance with the purpose.

### Photopolymerization Initiation System Sensitive to Light Within Wavelength Region of from Visible Light to Ultraviolet Light

The photopolymerization initiation system sensitive to light within a wavelength region of from visible light to ultraviolet light means a system that includes a compound capable of absorbing light within a wavelength region of from visible light to ultraviolet light to initiate photopolymerization. More specific examples thereof include a combination of a sensitizing colorant having a wavelength of maximum absorption in a wavelength region of from visible light to ultraviolet light, preferably from 330 nm to 700 nm, and a photopolymerization initiator. As the photopolymerization initiator, two or more photopolymerization initiators may be used (combined use system). As the photopolymerization initiation system, a sensitizing colorant (dye) and a photopolymerization initiator, or a sensitizing colorant (dye) and a combined use system of two or more photopolymerization initiators, may be appropriately selected in accordance with the wavelength of a light source to be employed, from various known systems disclosed in patents, publications and the like.

Various photoinitiation systems have been proposed also for cases in which a visible light having a wavelength of 400 nm or greater, an Ar laser, a second harmonic wave of a semiconductor laser, or a SHG-YAG laser is used as the light source. Examples thereof include: photoreducable dyes described in US Patent No. 2,850,445, such as Rose Bengal, eosin, erythrosine; and systems including a combination a dye and an initiator, such as a complex initiation system of a dye and an amine (Japanese Patent Publication (JP-B) No. S44-20189), a combination system of hexaaryl biimidazole, a radical generator, and a dye (JP-B No. S45-37377), a system of hexaaryl biimidazole and p-dialkylamino benzylidene ketone (JP-B No. S47-2528 and JP-A No. S54-155292), a system of a cyclic cis-α-dicarbonyl compound and a dye (JP-ANo. S48-84183), a system of a cyclic triazine and a merocyanine colorant (JP-A No. S54-151024), a system of 3-ketocoumarin and an activator (JP-A Nos. S52-112681 and S58-15503), a system of a biimidazole, a styrene derivative, and a thiol (JP-A No. S59-140203), a system of an organic peroxide and a colorant (JP-A Nos. S59-1504, S59-140203, S59-189340, and S62-174203, JP-B No. S62-1641, and US Patent No. 4766055), a system of a dye and an activated halogen compound (such as JP-ANos. S63-258903 and H02-63054), a system of a dye and a borate compound (such as JP-ANos. S62-143044, S62-150242, S64-13140, S64-13141, S64-13142, S64-13143, S64-13144, S64-17048, H01-229003, H01-298348, and H01-138204), a system of a colorant having a rhodanine ring and a radical generator (JP-A Nos. H02-179643 and H02-244050), a system of titanocene and a 3-ketocoumarin colorant (JP-ANo. S63-221110), a system in which titanocene, a xanthene colorant, and an addition-polymerizable ethylenically unsaturated compound having an amino group or a urethane group are combined (JP-ANos. H04-221958 and H04-219756), a system of a titanocene and a specific merocyanine colorant (JP-A No. H06-295061), and a system of titanocene and a colorant having a benzopyran ring (JP-A No. H08-334897).

Lasers having a wavelength of from 400 nm to 410 nm (violet lasers) have recently been developed, and photopolymerization initiation systems that are sensitive to those lasers and exhibit high sensitivity to wavelengths of 450 nm or less have been developed. These photoinitiation systems are also usable. Examples thereof include a cation colorant/borate system (JP-A H11-84647), a merocyanine colorant/titanocene system (JP-A No. 2000-147763), and a carbazole colorant/titanocene system (JP-ANo. 2001-42524).

It is known that the photoinitiation power can be further enhanced by adding, to the photoinitiation system described above, a hydrogen donating compound as necessary, the examples of the hydrogen donating compound including a thiol compound such as 2-mercaptobenzthiazole, 2-mercaptobenzimidazole, or 2-mercaptobenzoxazole, and an amine compound such as N-phenylglycine or N,N-dialkylamino aromatic alkylester. The amount of photopolymerization initiation system, such as those described above, to be employed may be within a range of from 0.05 parts by mass to 100 parts by mass, preferably within a range of from 0.1 parts by mass to 70 parts by mass, and more preferably within a range of from 0.2 parts by mass to 50 parts by mass, with respect to 100 parts by mass of the ethylenically unsaturated compound described below.

Polymerizable Compound Having At Least One Ethylenically Unsaturated Group The polymerizable compound having at least one ethylenically unsaturated group (also referred to below as an ethylenically unsaturated bond-containing compound) is a compound that has an ethylenically unsaturated bond, and that undergoes addition polymerization due to the action of a photopolymerization initiator to crosslink and cure when a photosensitive composition is irradiated with an actinic light. The addition-polymerizable ethylenically unsaturated bond-containing compound may be freely selected from compounds each containing at least one ethylenically unsaturated terminal bond, and more preferably selected from compounds each containing two or more ethylenically unsaturated terminal bonds. The ethylenically unsaturated bond-containing compound may have a chemical form, for example, a monomer, a prepolymer which is a dimer, a trimer, or an oligomer, or a mixture or copolymer thereof.

Examples of monomers and copolymers thereof include an ester of an unsaturated carboxylic acid (such as acrylic acid, methacrylic acid, itaconic acid, crotonic acid, isocrotonic acid or maleic acid) and an aliphatic polyhydric alcohol compound, and an amide of an unsaturated carboxylic acid and an aliphatic polyamine compound.

Specific examples of a monomer that is an ester of an aliphatic polyhydric alcohol compound and an unsaturated carboxylic acid include: acrylic acid esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylol propane triacrylate, trimethylol propane tri(acryloyloxypropyl)ether, trimethylol ethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate, and a polyester acrylate oligomer;

methacrylic acid esters such as tetramethylene glycol dimethacrylate, triethylene glycol dimethacrylate, neopentyl glycol dimethacrylate, trimethylol propane trimethacrylate, trimethylol ethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis [p-(3-methacryloxy-2-hydroxy propoxy) phenyl] dimethyl methane, and bis-[p-(methacryloxyethoxy)phenyl] dimethylmethane;

itaconic acid esters such as ethylene glycol diitaconate, propylene glycol diitaconate, 1,5-butanediol diitaconate, 1,4-butanediol diitaconate, tetramethylene glycol diitaconate, pentaerythritol diitaconate, and sorbitol tetraitaconate;
crotonic acid esters such as ethylene glycol dicrotonate, tetramethylene glycol dicrotonate, pentaerythritol dicrotonate, and sorbitol tetradicrotonate;
isocrotonic acid esters such as ethylene glycol diisocrotonate, pentaerythritol diisocrotonate, and sorbitol tetraisocrotonate; and

maleic acid esters such as ethylene glycol dimaleate, triethylene glycol dimaleate, pentaerythritol dimaleate, and sorbitol tetramaleate.

Examples further include any mixtures of the ester monomers described above. Specific examples of a monomer that is an amide of an aliphatic polyamine compound and an unsaturated carboxylic acid include methylene bis-acrylamide, methylene bis-methacrylamide, 1,6-hexamethylene bis-acrylamide, 1,6-hexamethylene bis-methacrylamide, diethylene triamine trisacrylamide, xylylene bisacrylamide, and xylylene bismethacrylamide.

Other examples include a vinyl urethane compound described in JP-B No. S48-41708 that includes two or more polymerizable vinyl groups in a molecule thereof, and that is obtained by addition of a vinyl monomer having a hydroxyl group and represented by the following Formula (A), to a polyisocyanate compound having two or more isocyanate groups within a molecule thereof.

CH₂=C(R)COOCH₂CH(R')OH (A)

Each of R and R' represents H or CH₃.

Examples further include urethane acrylates, such as those described in JP-A No. S51-37193 and JP-B H02-32293, polyester acrylates such as those described in JP-A No. S48-64183 and JP-B Nos. S49-43191 and S52-30490, and polyfunctional acrylates or methacrylates, such as an epoxy acrylate formed by a reaction of an epoxy resin and (meth) acrylic acid.

### Binder Polymer

Since a binder polymer (polymeric binder) in the image recording layer formed from the photopolymerization photosensitive composition should dissolve in alkali developer liquid as well as serve as a film-forming agent of the image recording layer, an organic macromolecular polymer that is soluble or swellable in alkali water may be employed as the binder polymer.

Organic macromolecular polymers of this type include addition polymers that have a carboxylic acid group at a side chain, for example, those described in JP-ANo. S59-44615, JP-B Nos. S54-34327, S58-12577, and S54-25957, and JP-ANos. S54-92723, S59-53836, and S59-71048, more specifically, methacrylic acid copolymers, acrylic acid copolymers, itaconic acid copolymers, crotonic acid copolymers, maleic acid copolymers, and partially esterified maleic acid copolymers.

Further examples include acidic cellulose derivatives that have a carboxylic acid group at a side chain. Other than those described above, products each obtained by adding a cyclic acid anhydride to an addition polymer having a hydroxyl group are useful. Particularly preferable polymers among these are a copolymer of benzyl (meth)acrylate, (meth)acrylic acid , and, if necessary, another addition polymerizable vinyl monomer, and a copolymer of allyl (meth)acrylate, (meth) acrylic acid, and, if necessary. another addition polymerizable vinyl monomer. Other than these, useful water soluble organic macromolecules include polyvinyl pyrrolidone and polyethylene oxide. Alcohol-soluble polyamides, polyethers of 2,2-bis-(4-hydroxyphenyl)-propane and epichlorohydrin, and the like, are useful for raising the strength of cured film.

Polyurethane resins described in JP-B Nos. H07-120040, H07-120041, H07-120042, and H08-12424, and JP-ANos. S63-287944, S63-287947, H01-271741, and H11-352691 are also useful for use in the invention.

The strength of the cured film can be enhanced by introducing a radical-reactive group into a side chain of the macromolecular polymer. Examples of functional groups capable of undergoing an addition polymerization reaction include an ethylenically unsaturated bond group, an amino group, and an epoxy group, and examples of functional groups that can form a radical when irradiated with light include a mercapto group, a thiol group, a halogen atom, a triazine structure, and an onium salt structure. An ethylenically unsaturated bond group such as an acrylic group, a methacrylic group, an allyl group, or a styryl group is particularly preferable as the functional group capable of undergoing an addition polymerization reaction. A functional group selected from the group consisting of an amino group, a hydroxy group, a phosphonic acid group, a phosphoric acid group, a carbamoyl group, an isocyanate group, a ureido group, a ureylene group, a sulfonic acid group, and an ammonio group is also useful as the functional group capable of undergoing an addition polymerization reaction.

To maintain the developability of the image recording layer, the binder polymer preferably has a suitable molecular weight and a suitable acid value, and a macromolecular polymer having a weight average molecular weight of from 5,000 to 300,000 and an acid value of from 20 to 200 can be employed effectively.

The binder polymers to be mixed into the photopolymerization photosensitive layer composition may be an arbitrary amount, and is preferably from 10% to 90%, and more preferably from 30% to 80%, with respect to the entire photopolymerization photosensitive layer composition. An amount of the binder polymer of 90% by mass or less is preferable as favorable results are obtained from the standpoints of, for example, the strength of the formed image. The photopolymerizable ethylenically unsaturated bond-containing compound and the binder polymer preferably have a mass ratio within a range of from 1/9 to 9/1. The mass ratio is more preferably in the range of from 2/8 to 8/2, and still more preferably from 3/7 to 7/3.

### Other Components

To the image recording layer described above, other than the above basic components, it is preferable to add a small amount of thermal polymerization inhibitor in order to prevent undesirable thermal polymerization of the photopolymerizable ethylenically unsaturated compound during the production or storage of the photosensitive composition.

For the purpose of coloring the image recording layer, a coloring agent may be added. Examples of the coloring agent include phthalocyanine pigments (C.I. Pigment Blue 15:3, 15:4, 15:6 and the like), azo pigments, carbon black, pigments such as titanium oxide, ethyl violet, crystal violet, azo dyes, anthraquinone dyes, and cyanine dyes.

### Thermal-polymerization Photosensitive Composition

Explanation will next be given regarding the thermal-polymerization photosensitive composition for forming a photosensitive image recording layer of a planographic printing plate precursor used in the invention. The thermal-polymerization photosensitive composition usually includes an infrared absorbent, a polymerization initiator, an ethylenically unsaturated bond-containing monomer, and a binder polymer.

### Infrared Absorbent

The infrared absorbent has the function of converting infrared rays absorbed by the infrared absorbent into heat. The polymerization initiator (radical generator), described below, thermally decomposes due to the generated heat, and generates a radical. The infrared absorbent employed in the invention is preferably a dye or pigment having a wavelength of maximum absorption of from 760 nm to 1200 nm.

Commercial dyes and known dyes described in publications such as "Senryo Binran" (published by the Society of Synthetic Organic Chemistry, 1970 edition) can be used as dyes. Specific examples of dyes that may be used include azo dyes, metal complex salt azo dyes, pyrazolone azo dyes, naphthoquinone dyes, anthraquinone dyes, phthalocyanine dyes, carbonium dyes, quinone imine dyes, methine dyes, cyanine dyes, squarylium colorants, pyrylium salts, and metal thiolate complexes.

Examples of preferable dyes include cyanine dyes such as those described in JP-A Nos. S58-125246, S59-84356, S59-202829, and S60-78787, methine dyes such as those described in JP-ANos. S58-173696, S58-181690, and S58-194595, naphthoquinone dyes such as those described in JP-ANos. S58-112793, S58-222793, S59-48187, S59-73996, S60-52940, and S60-63744, squarylium colorants such as those described in JP-A No. S58-112792 and the like, and cyanine dyes such as those described in U.K. Patent No. 434,875 and the like.

A near-infrared absorption sensitizer described in the specification of US Patent No. 5,156,938 is also suitable for use. Use of a substituted arylbenzo(thio)pyrylium salt described in the specification of US Patent No. 3,881,924, a trimethine thiapyrylium salt described in the specification of JP-A No. S57-142645 (US Patent No. 4,327,169), a pyrylium compound described in JP-ANo. S58-181051, S58-220143, S59-41363, S59-84248, S59-84249, S59-146063, or S59-146061, a cyanine colorant described in JP-A No. S59-216146, a pentamethine thiopyrylium salt or the like described in the specification of US Patent No. 4,283,475, or a pyrylium compound described in JP-B No. H05-13514 or H05-19702 is also preferable. Other preferable examples of dyes include a near-infrared absorbing dye described as formulas (I) or (II) in the specification of US Patent No. 4,756,993.

Other examples of preferable infrared absorbents include a specific indolenine cyanine colorant described in JP-A No. 2002-278057.

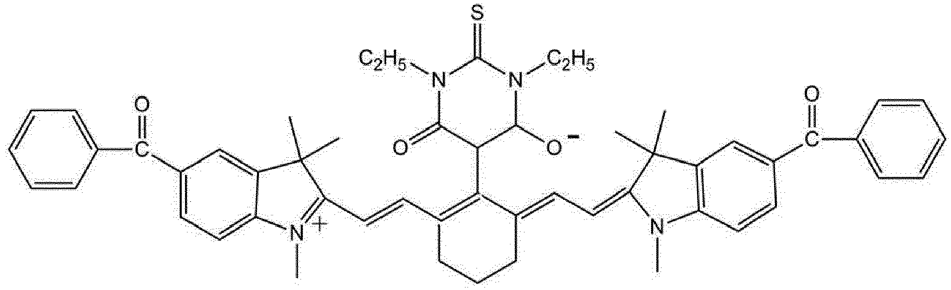

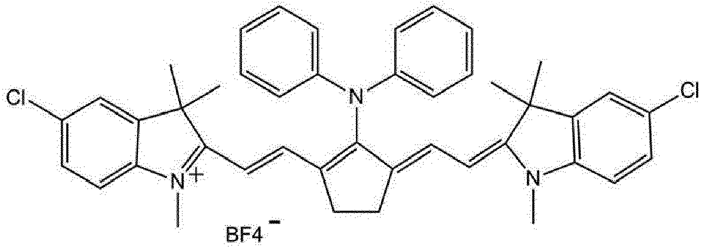

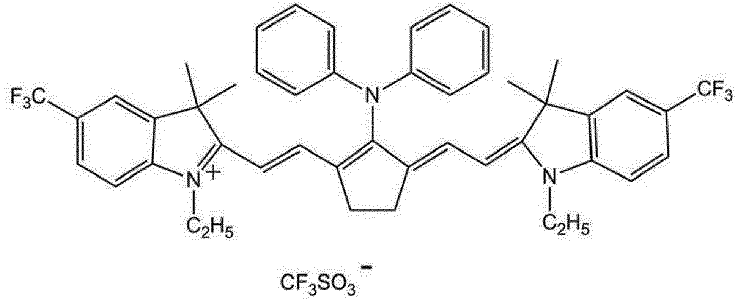

Among the dyes described above, particularly preferable dyes include cyanine colorants, squarylium colorants, pyrylium salts, nickel thiolate complexes and indolenine cyanine colorants. Cyanine colorants and indolenine cyanine colorants are more preferable. Particularly preferable examples of dyes include a cyanine dye represented by Formula (a).

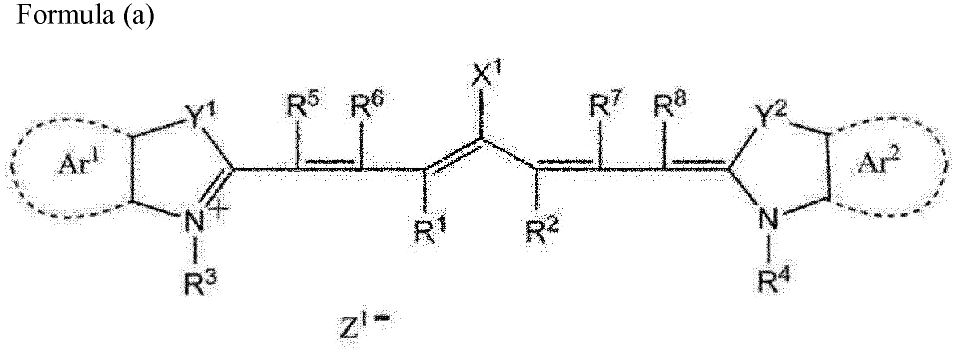

In Formula (a), X¹ represents a hydrogen atom, a halogen atom, -NPh₂, X²-L¹ or a group shown below. Here, X² represents an oxygen atom, a nitrogen atom, or a sulfur atom, and L¹ represents a hydrocarbon group having from 1 to 12 carbon atoms, an aromatic ring having a heteroatom, or a hydrocarbon group having from 1 to 12 carbon atoms and containing a heteroatom. Note that the term heteroatom refers to N, S, O, a halogen atom, or Se.

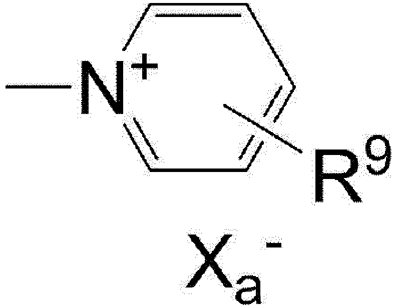

Xa⁻ has the same definition as that of Z¹⁻ described below. R⁹ represents a substituent selected from the group consisting of a hydrogen atom, an alkyl group, an aryl group, a substituted or unsubstituted amino group, and a halogen atom.

Each of R¹ and R² independently represents a hydrocarbon group having from 1 to 12 carbon atoms. From the standpoint of the storage stability of the recording layer coating liquid, each of R¹ and R² is preferably a hydrocarbon group having two or more carbon atoms. It is particularly preferable that R¹ and R² are bonded to each other to form a 5-membered or 6-membered ring.

Ar¹ and Ar² may be the same as, or different from, each other, and each represent an aromatic hydrocarbon group that may have a substituent. Preferable examples of the aromatic hydrocarbon group include a benzene ring and a naphthalene ring. Preferable examples of the substituent include a hydrocarbon group having 12 or fewer carbon atoms, a halogen atom, and an alkoxy group having 12 or fewer carbon atoms. Y¹ and Y² may be the same as, or different from, each other, and each represent a sulfur atom or a dialkylmethylene group having 12 or fewer carbon atoms. R³ and R⁴ may be the same as, or different from, each other, and each represent a hydrocarbon group that has 20 or fewer carbon atoms, and that may have a substituent. Preferable examples of the substituent include an alkoxy group having 12 or fewer carbon atoms, a carboxyl group and a sulfo group. R⁵, R⁶, R⁷ and R⁸ may be the same as, or different from, each other, and each represent a hydrogen atom or a hydrocarbon group having 12 or fewer carbon atoms. From the standpoint of the availability of raw materials, each of R⁵, R⁶, R⁷ and R⁸ is preferably a hydrogen atom. Z¹⁻ represents a counter anion. Z¹⁻ is not necessary in cases in which the cyanine colorant represented by Formula (a) has an anionic substituent within a structure thereof, and charge neutralization is not necessary. From the standpoint of the storage stability of the recording layer coating liquid, Z¹⁻ is preferably a halogen ion, a perchloric acid ion, a tetrafluoroborate ion, a hexafluorophosphate ion, or a sulfonic acid ion, and particularly preferably a perchloric acid ion, a hexafluorophosphate ion, or an arylsulfonic acid ion.

In cases in which a thermal-polymerization photosensitive composition is used in an image recording layer of a photosensitive planographic printing plate precursor, the infrared absorbent may be added into the same layer as other components, or another layer may be provided and the infrared absorbent may be added thereto. During production of the negative-working photosensitive planographic printing plate precursor, the infrared absorbent is added such that the absorbance of the image recording layer at the wavelength of maximum absorption in the wavelength region of from 760 nm to 1200 nm is within a range of from 0.5 to 1.2 as measured by reflectometry. The absorbance is preferably within the range of from 0.6 to 1.15.

### Polymerization Initiator

The thermal-polymerization photosensitive composition includes a sulfonium salt polymerization initiator as a polymerization initiator that initiates and promotes a curing reaction of the polymerizable compound described below. The sulfonium salt polymerization initiator is a thermally-decomposable radical generator that is decomposed by heat to generate a radical. In the invention, by using a sulfonium salt polymerization initiator and the infrared absorbent described above in combination, the infrared absorbent generates heat when irradiated with an infrared laser, and a radical can be generated due to the heat. In the invention, this combination is preferable since the combination enables high-sensitivity heat mode recording.

Examples of sulfonium salt polymerization initiators that can suitably be used in the invention include an onium salt represented by Formula (I) below.

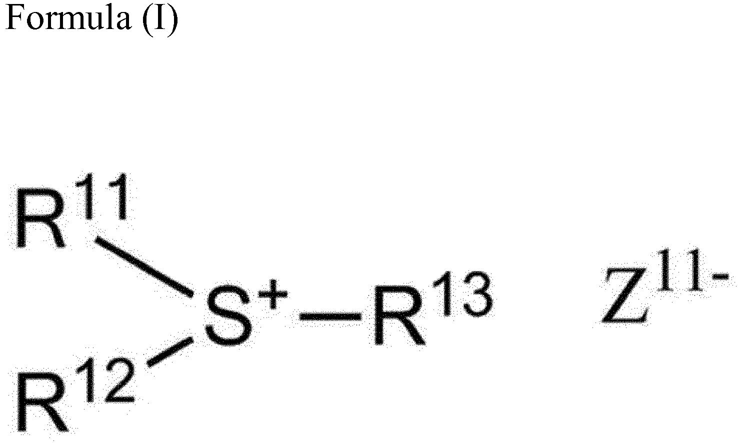

In Formula (I), R¹¹, R¹², and R¹³ each may be the same as, or different from, each other, and each represent a hydrocarbon group having 20 or fewer carbon atoms that may have a substituent. Preferable examples of the substituent include a halogen atom, a nitro group, an alkyl group having 12 or fewer carbon atoms, an alkoxy group having 12 or fewer carbon atoms, and an aryloxy group having 12 or fewer carbon atoms. Z¹¹⁻ represents a counter ion selected from the group consisting of a halogen ion, a perchloric acid ion, a tetrafluoroborate ion, a hexafluorophosphate ion, a carboxylate ion, and a sulfonic acid ion. Z¹¹⁻ is preferably a perchloric acid ion, a hexafluorophosphate ion, a carboxylate ion, or an arylsulfonic acid ion.

Specific examples of onium salts represented by Formula (I) include [OS-1] to [OS-10] described in JP-ANo. 2006-220931; however, specific examples of onium salts are not limited thereto.

Other than the compounds described above, specific aromatic sulfonium salts described in JP-A Nos. 2002-148790, 2002-148790, 2002-350207 and 2002-6482 are also favorable.

In the invention, besides the sulfonium salt polymerization initiator described above, another polymerization initiator (another radical generator) may additionally be used.

Examples of other radical generators include onium salts other than sulfonium salts, triazine compounds having a trihalomethyl group, peroxides, azo polymerization initiators, azide compounds, quinone diazide, oxime ester compounds, and triaryl monoalkylborate compounds. Of these, onium salts are highly sensitive and are preferable.

Examples of other onium salts that can be suitably used in the invention include iodonium salts and diazonium salts. In the invention, these onium salts do not function as acid generators, but function as initiators for radical polymerization.

Examples of other onium salts in the invention include onium salts represented by Formulas (II) and (III) below.

Formula (II) Ar²-I⁺- Ar²² Z²¹⁻

Formula (III) Ar³¹-N⁺≡N Z³¹⁻

In Formula (II), each of Ar²¹ and Ar²² independently represents an aryl group having 20 or fewer carbon atoms that may have a substituent. When the aryl group has a substituent, preferable examples of the substituent include a halogen atom, a nitro group, an alkyl group having 12 or fewer carbon atoms, an alkoxy group having 12 or fewer carbon atoms, and an aryloxy group having 12 or fewer carbon atoms. Z²¹⁻ represents a counter ion having the same definition as Z¹¹⁻ in Formula (I).

In Formula (III), A³¹ represents an aryl group having 20 or fewer carbon atoms that may have a substituent. Preferable examples of the substituent include a halogen atom, a nitro group, an alkyl group having 12 or fewer carbon atoms, an alkoxy group having 12 or fewer carbon atoms, an aryloxy group having 12 or fewer carbon atoms, an alkylamino group having 12 or fewer carbon atoms, a dialkylamino group having 12 or fewer carbon atoms, an arylamino group having 12 or fewer carbon atoms, and a diarylamino group having 12 or fewer carbon atoms. Z³¹⁻ represents a counter ion having the same definition as Z¹¹⁻ in Formula (I).

Onium salts represented by Formula (II) and Formula (III) that may be suitably used in the invention include, but are not limited to, [OI-1] to [OI-10] and [ON-1] to [ON-5] described in JP-A No. 2006-220931.

Specific examples of onium salts that may be suitably used as polymerization initiators (radical generators) include those described in JP-A No. 2001-133696.

Note that the polymerization initiator (radical generator) preferably has a wavelength of maximum absorption of 400 nm or less, more preferably 360 nm or less. By setting the absorption wavelength to be in the ultra-violet region, the photosensitive planographic printing plate precursor can be handled under white light.

The total content of polymerization initiator in the thermal-polymerization photosensitive composition is from 0.1% by mass to 50% by mass, preferably from 0.5% by mass to 30% by mass, and particularly preferably from 1% by mass to 20% by mass, with respect to the total solid content. By setting the content to 0.1% by mass or greater, favorable sensitivity can be obtained. When the content is 50% by mass or less, contamination does not occur in non-image areas during printing in cases in which the thermal-polymerization photosensitive composition is used in an image recording layer of a photosensitive planographic printing plate precursor.

The photopolymerization initiator particularly preferably includes a sulfonium salt photopolymerization initiator. The sulfonium salt photopolymerization initiator may be used singly, or in combination of two or more thereof. In cases in which two or more photopolymerization initiators are used in combination, the photopolymerization initiators may include only plural sulfonium salt photopolymerization initiators, or include a sulfonium salt photopolymerization initiator and another photopolymerization initiator in combination.

In cases in which a sulfonium salt photopolymerization initiator and another photopolymerization initiator are used in combination, the content ratio (mass ratio) of sulfonium salt photopolymerization initiator to other photopolymerization initiator is preferably from 100/1 to 100/50, and more preferably from 100/5 to 100/25.

### Polymerizable Compound

The polymerizable compound used in the thermal-polymerization photosensitive composition is an addition-polymerizable compound having at least one ethylenically unsaturated double bond, and is selected from compounds having at least one ethylenically unsaturated bond, and is preferably selected from compounds having two or more ethylenically unsaturated bonds. This group of compounds is widely known in the present industrial field, and these compounds may be used in the invention with no particular limitations. The compounds have a chemical form of, for example: a monomer; a prepolymer, namely, a dimer, a trimer, or an oligomer; or a mixture or copolymer thereof. Examples of monomers and copolymers thereof include unsaturated carboxylic acids (such as acrylic acid, methacrylic acid, itaconic acid, crotonic acid, isocrotonic acid, and maleic acid), and esters and amides thereof. Preferably an ester of an unsaturated carboxylic acid and an aliphatic polyhydric alcohol compound, or an amide of an unsaturated carboxylic acid and an aliphatic polyamine compound is used. An addition reaction product between an unsaturated carboxylic acid ester or amide having a nucleophilic substituent, such as a hydroxyl group, an amino group, or a mercapto group, and a monofunctional isocyanate, a polyfunctional isocyanate, or an epoxy, and a dehydration condensation reaction product between the unsaturated carboxylic acid ester or amide and a monofunctional or polyfunctional carboxylic acid, are also highly suitable for use. An addition reaction product between an unsaturated carboxylic acid ester or amide having an electrophilic group substituent, such as an isocyanate group or an epoxy group, and a monofunctional or a polyfunctional alcohol, amine, or thiol, and a substitution reaction product between an unsaturated carboxylic acid ester or amide having a leaving group substituent, such as a halogen group or a tosyloxy group, and a monofunctional or a polyfunctional alcohol, amine, or thiol, are also highly suitable. A group of compounds obtained by modifying the above compounds by replacing the unsaturated carboxylic acid with an unsaturated phosphonic acid, styrene, or vinyl ether can be used as other examples.

Specific examples of the polymerizable compound include the above-described substances that can be used as the ethylenically unsaturated bond-containing compound in the photopolymerization photosensitive composition.

As other examples of esters, aliphatic alcohol esters described in JP-B Nos. S46-27926 and S51-47334 and JP-ANo. S57-196231, substances having an aromatic skeleton described in JP-ANos. S59-5240, S59-5241, and H02-226149, and substances having an amino group described in JP-A No. H01-165613, are also highly suitable for use. The ester monomer described above may be used in the form of a mixture.

### Binder Polymer

The binder polymer used in the thermal-polymerization photosensitive composition is included from the standpoint of enhancing film properties, and various types of polymers may be used therefor provided they function to enhance film properties. In particular, a binder polymer highly suitable for use in the thermal-polymerization photosensitive composition according to the invention is a binder polymer having a repeating unit represented by Formula (i) below. This polymer is also referred to below as "specific binder polymer", and is described in detail below.

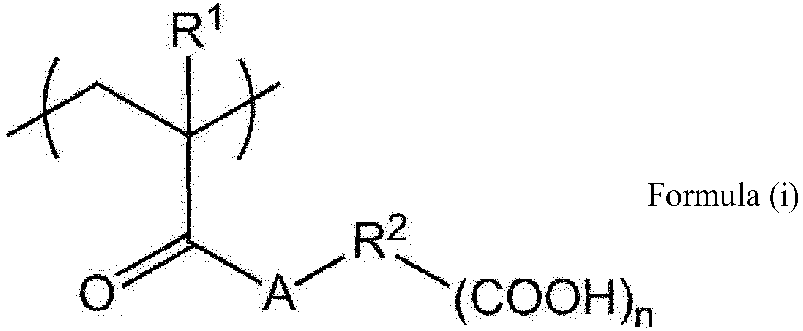

In Formula (i), R¹ represents a hydrogen atom or a methyl group; R² represents a linking group; A represents an oxygen atom or NR³-; R³ represents a hydrogen atom or a monovalent hydrocarbon group having from 1 to 10 carbon atoms; and n represents an integer from 1 to 5.

The linking group represented by R² in Formula (i) is formed from an atom or a group of atoms selected from the group consisting of hydrogen atoms, oxygen atoms, nitrogen atoms, sulfur atoms, and halogen atoms. In the linking group, the number of atoms, excluding the atoms of substituents if any, may be from 2 to 30. Specific examples the linking group include an alkylene, a substituted alkylene, an arylene, and a substituted arylene, and a structure obtained by linking plural bivalent groups selected therefrom with one or more amide bonds or ester bonds.

In cases in which the linking group represented by R² has a chain structure, examples of the linking group having a chain structure include ethylene and propylene. Another preferable example of the linking group is a structure obtained by linking two or more of the alkylene described above through one or more ester bonds.

Out of these, the linking group represented by R² in Formula (i) is preferably a (n+1) valent hydrocarbon group having an aliphatic cyclic structure having from 3 to 30 carbon atoms. More specific examples include (n+1)-valent hydrocarbon group obtained by removing (n+1) hydrogen atoms from a freely-selected carbon atom or freely-selected carbon atoms in a compound having an aliphatic cyclic structure, such as cyclopropane, cyclopentane, cyclohexane, cycloheptane, cyclooctane, cyclodecane, dicyclohexyl, tercyclohexyl, or norbornane, that may be substituted by one or more freely-selected substituents. R² preferably has from 3 to 30 carbon atoms including the carbon atoms of substituents if any.

One or more freely-selected carbon atoms of a compound forming the aliphatic cyclic structure may be replaced by a heteroatom selected from the group consisting of a nitrogen atom, an oxygen atom, and a sulfur atom. From the standpoint of printing durability, R² is preferably an (n+1)-valent hydrocarbon group having an aliphatic ring structure that includes two or more rings, that has from 5 to 30 carbon atoms, and that may have a substituent, such as a condensed polycyclic aliphatic hydrocarbon, a bridged cyclic aliphatic hydrocarbon, a spiro aliphatic hydrocarbon, or an aliphatic hydrocarbon ring cluster (plural rings that are connected by one or more bonds or one or more linking groups). Also in this case, the number of carbon atoms includes the number of carbon atoms of substituents, if any.

It is more preferable that the linking group represented by R² has from 5 to 10 carbon atoms. The structure of the linking group represented by R² is preferably a chain structure having an ester bond therein or a chain structure having therein a ring structure such as those described above.

Examples of substituents that may be introduced to the linking group represented by R² include a monovalent non-metal atomic group other than hydrogen, and more specifically include: a halogen atom (-F,-Br,-Cl,-I), a hydroxyl group, an alkoxy group, an aryloxy group, a mercapto group, an alkylthio group, an arylthio group, an alkyldithio group, an aryldithio group, an amino group, a N-alkylamino group, a N,N-dialkylamino group, aN-arylamino group, a N,N-diarylamino group, a N-alkyl-N-arylamino group, an acyloxy group, a carbamoyloxy group, a N-alkylcarbamoyloxy group, a N-arylcarbamoyloxy group, N,N-dialkylcarbamoyloxy group, a N,N-diarylcarbamoyloxy group, a N-alkyl-N-aryl carbamoyloxy group, an alkylsulfoxy group, an arylsulfoxy group, an acylthio group, an acylamino group, a N-alkylacyl amino group, a N-arylacyl amino group, a ureido group, a N'-alkylureido group, a N',N'-dialkylureido group, a N'-arylureido group, a N',N'-diarylureido group, a N'-alkyl-N'-arylureido group, a N-alkylureido group, a N-arylureido group, a N'-alkyl-N-alkylureido group, a N'-alkyl-N-arylureido group, a N',N'-dialkyl-N-alkylureido group, a N',N'-dialkyl-N-arylureido group, a N'-aryl-N-alkylureido group, a N'-aryl-N-arylureido group, a N',N'-diaryl-N-alkylureido group, a N',N'-diaryl-N-arylureido group, a N'-alkyl-N'-aryl-N-alkylureido group, N'-alkyl-N'-aryl-N-arylureido group, an alkoxycarbonylamino group, an aryloxycarbonylamino group, a N-alkyl-N-alkoxycarbonylamino group, a N-alkyl-N-aryloxycarbonylamino group, a N-aryl-N-alkoxycarbonylamino group, a N-aryl-N-aryloxycarbonylamino group, a formyl group, an acyl group, a carboxyl group and conjugate bases thereof, an alkoxycarbonyl group, an aryloxycarbonyl group, a carbamoyl group, a N-alkylcarbamoyl group, a N,N-dialkylcarbamoyl group, a N-arylcarbamoyl group, a N,N-diarylcarbamoyl group, a N-alkyl-N-arylcarbamoyl group, an alkylsulfinyl group, an arylsulfinyl group, an alkylsulfonyl group, an arylsulfonyl group, a sulfo group (-SO₃H) and conjugate bases thereof, an alkoxysulfonyl group, an aryloxysulfonyl group, a sulfinamoyl group, a N-alkylsulfinamoyl group, a N,N-dialkylsulfinamoyl group, a N-arylsulfinamoyl group, a N,N-diarylsulfinamoyl group, N-alkyl-N-arylsulfinamoyl group, a sulfamoyl group, a N-alkylsulfamoyl group, a N,N-dialkylsulfamoyl group, a N-arylsulfamoyl group, a N,N-diarylsulfamoyl group, a N-alkyl-N-arylsulfamoyl group, a N-acylsulfamoyl group and conjugate bases thereof, a N-alkylsulfonyl sulfamoyl group (-SO₂NHSO₂(alkyl)) and conjugate bases thereof, N-arylsulfonyl sulfamoyl group (-SO₂NHSO₂(aryl)) and conjugate bases thereof, a N-alkylsulfonyl carbamoyl group (-CONHSO₂(alkyl)) and conjugate bases thereof, a N-arylsulfonyl carbamoyl group (-CONHSO₂(aryl)) and conjugate bases thereof, an alkoxysilyl group (-Si(O alkyl)₃), an aryloxysilyl group (-Si(O aryl)₃), a hydroxysilyl group (-Si(OH)₃) and conjugate bases thereof, a phosphono group (-PO₃H₂) and conjugate bases thereof, a dialkylphosphono group (-PO₃(alkyl)₂), a diarylphosphono group (-PO₃(aryl)₂), an alkyl aryl phosphono group (-PO₃(alkyl)(aryl)), a monoalkyl phosphono group (-PO₃H(alkyl)) and conjugate bases thereof, a monoaryl phosphono group (-PO₃H(aryl)) and conjugate bases thereof, a phosphonooxy group (-OPO₃H₂) and conjugate bases thereof, a dialkyl phosphonooxy group (-OPO₃(alkyl)₂), a diaryl phosphonooxy group (-OPO₃(aryl)₂), an alkyl aryl phosphonooxy group (-OPO₃(alkyl)(aryl)), a monoalkyl phosphonooxy group (-OPO₃H(alkyl)) and conjugate bases thereof, a monoaryl phosphonooxy group (-OPO₃H(aryl)) and conjugate bases thereof, a cyano group, a nitro group, a dialkyl boryl group (-B(alkyl)₂), a diaryl boryl group (-B(aryl)₂), an alkyl aryl boryl group (-B(alkyl)(aryl)), a dihydroxyboryl group (-B(OH)₂) and conjugate bases thereof, an alkyl hydroxyboryl group (-B(alkyl)(OH)) and conjugate bases thereof, an aryl hydroxyboryl group (-B(aryl)(OH)) and conjugate bases thereof, an aryl group, an alkenyl group, and an alkynyl group.

When the thermal-polymerization photosensitive composition is applied to an image recording layer of a photosensitive planographic printing plate precursor, depending on the design of the image recording layer, substituents having hydrogen atoms capable of forming hydrogen bonding, in particular, substituents having acidity with an acid dissociation constant (pKa) lower than that of carboxylic acid, tend to lower printing durability and are therefore not preferable. Conversely, hydrophobic substituents such as halogen atoms, hydrocarbon groups (alkyl groups, aryl groups, alkenyl groups, and alkynyl groups), alkoxy groups, and aryloxy groups tend to enhance printing durability and are therefore preferable. In particular, when the ring structure is a 6-membered or fewer-membered monocyclic aliphatic hydrocarbon, such as cyclopentane or cyclohexane, the ring structure preferably has a hydrophobic substituent such as those described above. When possible, each substituent may bond with another substituent, or with a hydrocarbon group on which the substituent is located, to form a ring. The substituent may itself be substituted.

In cases in which A in Formula (i) represents NR³-, R³ represents a hydrogen atom or a monovalent hydrocarbon group having from 1 to 10 carbon atoms. Examples of the monovalent hydrocarbon having from 1 to 10 carbons represented by R³ include an alkyl group, an aryl group, an alkenyl group, and an alkynyl group. Specific examples of the alkyl group include a straight-chain, branched, or cyclic alkyl group having from 1 to 10 carbon atoms such as a methyl group, an ethyl group, a propyl group, a butyl group, a pentyl group, a hexyl group, a heptyl group, an octyl group, a nonyl group, a decyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclopentyl group, a cyclohexyl group, a 1-adamantyl group, or a 2-norbornyl group.

Specific examples of the aryl group include: an aryl group having from 1 to 10 carbon atoms such as a phenyl group, a naphthyl group, or an indenyl group; and a heteroaryl group having from 1 to 10 carbon atoms and including one heteroatom selected from the group consisting of a nitrogen atom, an oxygen atom, and a sulfur atom, such as a furyl group, a thienyl group, a pyrrolyl group, a pyridyl group, or a quinolyl group.

Specific examples of the alkenyl group include a straight-chain, branched, or cyclic alkenyl group having from 1 to 10 carbon atoms such as a vinyl group, a 1-propenyl group, a 1-butenyl group, a 1-methyl-1-propenyl group, a 1-cyclopentenyl group, or a 1-cyclohexenyl group.

Specific examples of the alkynyl group include an alkynyl group having from 1 to 10 carbons such as an ethynyl group, a 1-propynyl group, a 1-butynyl group, or a 1-octynyl group. Examples of a substituent that R³ may have include the above-described examples of a substituent that may be introduced into R². The number of carbon atoms in R³ is from 1 to 10 including the carbon atoms in substituents if any. In Formula (i), A is preferably an oxygen atom or -NH-, in consideration of ease of synthesis.

In Formula (i), n represents an integer of from 1 to 5. From the standpoint of printing, n is preferably 1.

Preferable specific examples of the repeating unit represented by Formula (i) include, but are not limited, to, specific examples described in paragraphs from [0134] to [0143] of JP-A No. 2006-220931.

The binder polymer may include only one type of repeating unit represented by Formula (i), or include two or more types of repeating unit represented by Formula (i). In the invention, the specific binder polymer used in the thermal-polymerization photosensitive composition may be a polymer made solely from repeating units represented by Formula (i). However, the specific binder polymer is usually a copolymer made from repeating units represented by Formula (i) combined with other copolymerization components. In the copolymer, the total content of repeating units represented by Formula (i) is appropriately decided based on the structure thereof and the design of the composition. The total content is preferably within a range of from 1% by mol to 99% by mol, more preferably from 5% by mol to 40% by mol, and still more preferably from 5% by mol to 20% by mol, with respect to the total molar amount of the components of the polymer.

When the binder polymer is a copolymer, any radical-polymerizable monomer that is conventionally known may be employed, without limitation, as a copolymerization component of the copolymer. Specific examples thereof include monomers described in "Macromolecule Data Handbook, Basic Edition (edited by Kobunshi Gakkai, BAIFUKAN (1986))". The copolymerization component may be used singly, or in combination of two or more thereof.

In the invention, the molecular weight of the specific binder polymer is set appropriately from the standpoint of image forming performance and the printing durability of the obtained planographic printing plate. Generally, when the molecular weight is high, the printing durability is excellent; however, there is a tendency for image forming performance to deteriorate. Conversely, when the molecular weight is low, the image forming performance improves; however, printing durability is lowered. The molecular weight is preferably within a range of from 2,000 to 1,000,000, more preferably from 5,000 to 500,000, and still more preferably from 10,000 to 200,000.

In the invention, the binder polymer used in the thermal-polymerization photosensitive composition may consist of the specific binder polymer, or may be a mixture of the specific binder polymer and one or more other binder polymers. The one or more binder polymers used in combination with the specific binder polymer are used within a range of from 1% by mass to 60% by mass, preferably from 1% by mass to 40% by mass, and still more preferably from 1% by mass to 20% by mass, with respect to the total mass of binder polymer components. As the one or more binder polymers that may be used in combination with the specific binder polymer, conventionally known binder polymers may be used without limitation. Specifically, binders having an acrylic main chain, urethane binders, and the like, which are frequently employed in the art, may suitably be used.

In the thermal-polymerization photosensitive composition, the total amount of the specific binder polymer and the one or more binder polymers that may be used in combination therewith, may be determined as appropriate. The total amount is generally within a range of from 10% by mass to 90% by mass, preferably 20% by mass to 80% by mass, and still more preferably from 30% by mass to 70% by mass, with respect to the total mass of non-volatile components in the composition.

The acid value (meq/g) of the binder polymer is preferably within a range of from 2.00 to 3.60.

### Other Binder Polymers That May Additionally Be Used

The one or more other binder polymers that may be used in combination with the specific binder polymer is preferably a binder polymer having a radical-polymerizable group. The radical-polymerizable group is not particularly limited provided it is capable of polymerizing via radicals. Examples thereof include an α-substituted methylacrylic group [-OC(=O)-C(-CH₂Z)=CH₂, in which Z represents a hydrocarbon group starting from a heteroatom], an acrylic group, a methacrylic group, an allyl group, and a styryl group, and, of these, an acrylic group and a methacrylic group are preferable.

The one or more other binder polymers that may be used in combination with the specific binder polymer preferably have an alkali-soluble group. The content of alkali-soluble groups (acid value as measured by neutralization titration) in the binder polymer is preferably from 0.1 mmol to 3.0 mmol, more preferably from 0.2 mmol to 2.0 mmol, and most preferably from 0.45 mmol to 1.0 mmol, per 1g of binder polymer. When the content is less than 0.1 mmol, there are cases in which precipitation occurs during development to generate development residues. When the content is greater than 3.0 mmol, there are cases in which the printing durability of a photosensitive planographic printing plate precursor containing the binder polymer has lowered printing durability due to excessively high hydrophilicity.

Besides the basic components described above, other components suitable for the use or production method may be added, as appropriate, to the photosensitive composition. Preferable examples of additives are given below.

### Polymerization Inhibitor

In the invention, it is desirable to add a small amount of thermal polymerization inhibitor in order to prevent undesirable thermal polymerization of a compound having a polymerizable ethylenically unsaturated double bond, namely the polymerizable compound. Examples of suitable thermal polymerization inhibitors include hydroquinone, p-methoxyphenol, di-t-butyl-p-cresol, pyrogallol, t-butyl catechol, benzoquinone, 4,4'-thiobis(3-methyl-6-t-butylphenol), 2,2'-methylene bis(4-methyl-6-t-butylphenol), and a cerous salt of N-nitrosophenyl hydroxy amine. The total amount of thermal polymerization inhibitor added is preferably from approximately 0.01% by mass to approximately 5% by mass with respect to the mass of non-volatile components in the entire composition. If necessary, a higher fatty acid derivative or like, such as behenic acid or behenic acid amide, may be added, and allowed to localize on a surface of the photosensitive layer during a process of drying after coating, so as to prevent polymerization inhibition due to oxygen. The total amount of higher fatty acid derivative added is preferably from approximately 0.5% by mass to approximately 10% by mass with respect to non-volatile components in the entire composition.

### Coloring Agent

For the purpose of coloring, a dye or pigment may be added to the thermal-polymerization photosensitive composition. As a result of the addition, plate inspectability of the printing plate, such as visibility after plate-making or suitability to image density measurement instruments, can be enhanced. For the coloring agent, it is particularly preferable to employ a pigment as the coloring agent as many dyes cause a drop in the sensitivity of an image recording layer (photosensitive layer) made from a thermally polymerizable composition. Specific examples include: pigments such as phthalocyanine pigments, azo pigments, carbon black, and titanium oxide; and dyes such as ethyl violet, crystal violet, azo dyes, anthraquinone dyes, and cyanine dyes. The amount of dyes and pigments as coloring agents is preferably from approximately 0.5% by mass to approximately 5% by mass with respect to non-volatile components in the entire composition.

### Other Additives

Known additives, such as inorganic fillers for improving the physical properties of a cured film as well as plasticizers and sensitizing agents capable of enhancing ink receptivity of a surface of an image recording layer, may be further added to the photosensitive composition. Examples of plasticizers include dioctyl phthalate, didodecyl phthalate, triethylene glycol dicaprylate, dimethyl glycol phthalate, tricresyl phosphate, dioctyl adipate, dibutyl sebacate, and triacetyl glycerin. The plasticizer may generally be added within a range of 10% by mass or less with respect to the total mass of the binder polymer and the addition polymerizable compound. The photosensitive composition may include a UV initiator or a thermal cross-linking agent for enhancing the effects of heating/light exposure after development, the heating/light exposure aiming to enhance the film strength (printing durability) of the image recording layer in the photosensitive planographic printing plate precursor described below.

The thermal-polymerization or photopolymerization photosensitive composition described above can be suitably used as an image recording layer (photosensitive layer) in the photosensitive planographic printing plate precursor described below.

### Photosensitive Planographic Printing Plate Precursor

The photosensitive planographic printing plate precursor is configured by layering a radical-polymerizable image recording layer and, optionally, a protective layer in this order on a support, the image recording layer including the photosensitive composition described above. The photosensitive planographic printing plate precursor may be produced by applying an image recording layer coating liquid that includes the photosensitive composition described above, and, if necessary, a coating liquid obtained by dissolving coating liquid components for a desired layer, such as a protective layer, in a solvent, onto an appropriate support, or onto an intermediate layer provided on a support.

### Image Recording Layer (Photosensitive Layer)

The image recording layer (hereafter also referred to as photosensitive layer) in the planographic printing plate precursor according to the invention is a negative-working photosensitive layer that includes the photosensitive composition described above, in particular the photopolymerization photosensitive composition or the thermal-polymerization photosensitive composition. The photopolymerizable or thermally-polymerizable negative-working photosensitive layer has a mechanism in which the polymerization initiator decomposes due to light or heat to generate a radical, and the generated radical causes the polymerizable compound to undergo a polymerization reaction. The photosensitive planographic printing plate precursor having the photosensitive layer is particularly suitable for plate-making using direct drawing with laser light having a wavelength of from 300 nm to 1,200 nm, and exhibits higher printing durability and image forming performance than conventional photosensitive planographic printing plate precursors.

The coating amount of the photosensitive layer mainly affects the sensitivity and developability of the photosensitive layer, and the strength and printing durability of the light-exposed film. Therefore, the coating amount is preferably selected in accordance with the applications. In cases in which the coating amount is too small, the printing durability is not sufficient. Conversely, cases in which the coating amount is too large are not preferable, due to sensitivity being reduced, exposure to light taking more time, and a longer time being required for development. For photosensitive planographic printing plate precursors for scanning exposure, which is a main application of the invention, an appropriate coating amount of the photosensitive layer is within a range of from approximately 0.1 g/m² to approximately 10 g/m² in terms of mass after drying, and more preferably from 0.5 g/m² to 5 g/m² in terms of mass after drying.

### Support

The support of the photosensitive planographic printing plate precursor according to the invention is preferably an aluminum support having a hydrophilic surface.

The aluminum plate refers to a metal plate of which the main component is dimensionally stable aluminum. The aluminum plate may be a pure aluminum plate, or selected from alloy plates that include aluminum as the main component and a small amount of other elements. In the following description, the substrate made of aluminum or the substrate made of an aluminum alloy will be referred to as an aluminum substrate. Examples of the other elements contained in the aluminum alloy include silicon, iron, manganese, copper, magnesium, chromium, zinc, bismuth, nickel, and titanium, and the content of the other elements in the alloy may be 10% by mass or lower. A pure aluminum plate is suited to the invention; however, since it is difficult to produce perfectly pure aluminum using refining technologies, the aluminum plate may include a small amount of other elements. As described above, the aluminum plate applied to the invention is not limited in terms of the composition thereof, and conventionally known materials may be utilized, as appropriate, such as JIS A 1050, JIS A 1100, JIS A 3103, and JIS A 3005.

The thickness of the aluminum substrate used in the invention is preferably from approximately 0.1 mm to approximately 0.6 mm. This thickness may be appropriately modified in accordance with the printing machine size, the printing plate precursor size, and user preferences. Depending on cases, the substrate surface processing described below may be carried out on the aluminum substrate, as appropriate.

### Surface Roughening

Methods for surface roughening include mechanical roughening, chemical etching, and electrolytic graining as described in JP-A No. S56-28893. Electrochemical surface roughening methods in which a surface is electrochemically roughened in a hydrochloric acid or nitric acid electrolytic solution, mechanical roughening methods such as a wire brush graining method in which an aluminum surface is scuffed with metal wires, a ball graining method in which an aluminum surface is grained with abrasive balls and an abrasive, and a brush graining method in which a surface is roughened with a nylon brush and an abrasive. These surface roughening methods may be used singly or in combination of two or more thereof. Of these methods, a method useful for use in roughening is an electrochemical method in which a surface is chemically roughened in a hydrochloric acid or nitric acid electrolytic solution, and a suitable anode time quantity of electricity is within a range of from 50 C/dm² to 400 C/dm². More specifically, alternating current and/or direct current electrolysis is preferably performed in an electrolytic solution containing from 0.1% by mass to 50% by mass hydrochloric acid or nitric acid under conditions of a temperature of from 20°C to 80°C, a duration of from 1 second to 30 minutes, and a current density of from 100 C/dm² to 400 C/dm².

The aluminum substrate that has been surface-roughened as described above may be chemically etched using acid or alkali. Etching agents that can be suitably used include caustic soda, sodium carbonate, sodium aluminate, sodium metasilicate, sodium phosphate, potassium hydroxide, and lithium hydroxide. Preferable ranges for the concentration and the temperature are from 1% by mass to 50% by mass, and from 20°C to 100°C, respectively. Pickling is performed to remove contaminants (smut) residual on the surface after etching. The acid used may be nitric acid, sulfuric acid, phosphoric acid, chromic acid, hydrofluoric acid, hydroftuoroboric acid, or the like. In particular, preferable examples of methods for desmutting after electrochemical surface roughening include a method including contacting with sulfuric acid at from 15% by mass to 65% by mass at a temperature of from 50°C to 90°C, as described in JP-A No. S53-12739, and an alkali etching method as described in JP-B No. S48-28123. There are no particular limitations to method or conditions as long as the center line average roughness Ra of the roughened surface is from 0.2 µm to 0.5 µm after roughening.

### Anodization

Anodization is then performed on the aluminum substrate that has been processed as described above and formed with an oxide layer.

In the anodization, an aqueous solution of sulfuric acid, phosphoric acid, oxalic acid or boric acid/sodium borate is employed singly, or in combination of two or more types thereof, as the primary component of an electrolytic bath. Components that are normally included in at least the Al alloy plate, the electrodes, tap water, and ground water, may be naturally included in the electrolytic solution. The electrolytic solution may further include a secondary component and/or a tertiary component. Examples of the secondary and tertiary components include metal ions such as Na, K, Mg, Li, Ca, Ti, Al, V, Cr, Mn, Fe, Co, Ni, Cu, and Zn, cations such as an ammonium ion, and anions such as a nitrate ion, a carbonate ion, a chloride ion, a phosphate ion, a fluoride ion, a sulfite ion, a titanate ion, a silicate ion, and a borate ion. The concentration thereof may be from approximately 0 ppm to approximately 10000 ppm. The conditions of the anodization are not particularly limited. The anodization is preferably performed using direct current or alternating current electrolysis at from 30 g/liter to 500 g/liter, at a processing liquid temperature of from 10°C to 70°C, and with a current density in a range of from 0.1 A/m² to 40 A/m². The thickness of the anodized film formed is within a range of from 0.5 µm to 1.5 µm, and is preferably within a range of from 0.5 µm to 1.0 µm. Conditions may be selected such that, in the support manufactured according to the above processes, the pore diameter of micropores present in the anodized film is from 5 nm to 10 nm, and the pore density is within a range of from 8×10¹⁵ pores/m² to 2×10¹⁶ pores/m².

Widely known methods may be applied as a process to impart hydrophilicity to the support surface. Particularly preferable processing is to perform a hydrophilicity-imparting process using a silicate, polyvinyl phosphonic acid, or the like. A coating film is formed with a Si or P element amount of preferably from 2 to 40 mg/m², and more preferably from 4 to 30 mg/m². The amount of coating may be measured using X-ray fluorescence analysis.

In the hydrophilicity-imparting process above, the aluminum substrate formed with an anodized film is immersed in an aqueous solution at from 15°C to 80°C for from 0.5 seconds to 120 seconds, the aqueous solution having a pH of from 10 to 13 at 25°C and containing an alkali metal silicate or polyvinyl phosphonic acid at preferably from 1% by mass to 30% by mass, more preferably from 2% by mass to 15% by mass..

In the photosensitive planographic printing plate precursor, an intermediate layer may be provided between the photosensitive layer and the support for the purpose of improving adhesion and contamination. In regard to specific examples of the intermediate layer, those described in the publications and specifications listed below can suitably be used: JP-B No. S50-7481 and JP-ANos. S54-72104, S59-101651, S60-149491, S60-232998, H03-56177, H04-282637, H05-16558, H05-246171, H07-159983, H07-314937, H08-202025, H08-320551, H09-34104, H09-236911, H09-269593, H10-69092, H10-115931, H10-161317, H10-260536, H10-282682, H11-84674, H11-38635, H11-38629, H10-282645, H10-301262, H11-327152, 2000-10292, 2000-235254, 2000-352824, and 2001-209170.

### Protective Layer (Overcoat Layer)

A protective layer is preferably provided on the photosensitive layer described above. The protective layer prevents incorporation into the photosensitive layer of low-molecular-weight compounds present in the atmosphere, such as oxygen and basic substances, from impeding an image forming reaction that occurs in the photosensitive layer due to exposure to light, thereby enabling light exposure to be performed in the atmosphere. The protective layer is provided basically in order to protect the photosensitive layer. In cases in which the photosensitive layer includes a radical-polymerization image forming mechanism, the protective layer has the role of an oxygen blocking layer, and in the case of exposure to a high-illuminance infrared laser, the protective layer performs the function of an ablation prevention layer.

Besides the properties described above, the protective layer is further desired to have properties such that the protective layer does not substantially hinder transmission of light used in exposure to light, and such that the protective layer exhibits excellent adhesion to the photosensitive layer, and such that the protective layer can easily be removed in the development process after exposure to light. Improvements concerning the protective layer have conventionally been made, and are described in detail in the specification of US Patent No. 3,458,311 and in JP-B No. S55-49729.

In regard to materials that can be used in the protective layer, for example, an aqueous macromolecular compound having comparatively excellent crystallinity is preferably used. Specific examples thereof include aqueous polymers such as polyvinyl alcohol, a copolymer of vinyl alcohol and vinyl phthalate, a copolymer of vinyl acetate, vinyl alcohol, and vinyl phthalate, a copolymer of vinyl acetate and crotonic acid, polyvinyl pyrrolidone, an acidic cellulose, gelatin, gum arabic, polyacrylic acid, and polyacrylamide. These may be used singly or in mixture of two or more thereof. Using polyvinyl alcohol, from out of these materials, as a main component provides a most favorable result in terms of fundamental characteristics such as oxygen blocking capability and removability at development.

A portion of the polyvinyl alcohol used in the protective layer may be substituted with an ester, an ether or an acetal, provided that an unsubstituted vinyl alcohol unit, which provides the necessary oxygen blocking capability and solubility in water, is included. Likewise, a portion of the polyvinyl alcohol may include another copolymerization component.

Specific examples of the polyvinyl alcohol include a substance that is from hydrolyzed to a degree of 71% to 100%, and that has a number of polymerization repeating units within a range of from 300 to 2400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 manufactured by Kuraray Co., Ltd.

The photosensitive planographic printing plate precursor produced as described above is image-wise exposed to light, thereafter subjected to development using the alkali developer liquid/development replenisher liquid described in detail above, and optionally subjected to optional processes such as a process of pre-washing with water, a rinse process (including a process of washing with water), the post-heating process described below, and a gumming process, as appropriate, as a result of which the photosensitive planographic printing plate precursor is made into a plate, and a planographic printing plate can be obtained.

Development is performed by supplying the exposed planographic printing plate precursor to the automatic developing machine 10 of Fig. 1.

Namely, to produce a planographic printing plate from the photosensitive planographic printing plate precursor, in the invention, at least an image-wise light exposure process and a development process are performed, and optional processes such as a water washing process also performed, if necessary.
- Light Exposure Process for Thermal-polymerization Photosensitive Planographic Printing Plate Precursor

In the plate-making method according to the invention, an infrared laser is a suitable example of the light source for the light exposure process for the thermal-polymerization photosensitive planographic printing plate precursor. Thermal recording using an ultraviolet lamp or a thermal head is also possible.

Examples of the light source of the actinic light used in the image-wise exposure of the photosensitive planographic printing plate precursor include a mercury lamp, a metal halide lamp, a xenon lamp, a chemical lamp, and a carbon arc lamp. Examples of the radiations include an electron beam, X-rays, an ion beam, and far-infrared rays. A g-line, an i-line, deep-UV rays, and a high density energy beam (laser beam) are also usable. Examples of the laser beam include a helium-neon laser, an argon laser, a krypton laser, a helium-cadmium laser, and a KrF excimer laser. In the invention, light sources having emission wavelengths in a region of from near infrared to infrared are preferable, and solid-state lasers and semiconductor lasers are particularly preferable.

Of these, the image-wise light exposure is preferably performed using a solid-state laser or a semiconductor laser that emits infrared radiation at a wavelength of from 750 nm to 1400 nm. The laser output is preferably 100 mW or greater, and the use of a multibeam laser device is preferable to shorten the exposure time. The exposure time per pixel is preferably within 20 µs. The energy that the photosensitive planographic printing plate precursor is irradiated with is preferably from 10 mJ/cm² to 300 mJ/cm². Curing of the image recording layer proceeds sufficiently with a light exposure energy within the above preferable range, and laser ablation is not likely to occur in the image recording layer at the time the image recording layer is exposed to light, as a result of which image damage is suppressed.

The exposure to light may be performed in such a manner that light beams from the light source are overlapped. Overlap means that the vertical scanning pitch is smaller than the beam diameter. When the beam diameter is expressed by, for example, the full width at half maximum (FWHM) of the beam intensity, overlap can quantitatively be expressed by the value of FWHM/vertical scanning pitch (overlap coefficient). In the invention, the overlap coefficient is preferably 0.1 or greater.

The scanning method for the light source of the exposure device employed in the above exposure process is not particularly limited, and may be a cylindrical outer surface scan method, a cylindrical inner surface scan method, or a flatbed scan method. The channel of the light source may be a single channel or multichannel, and multichannel is preferably employed in the case of a cylindrical outer surface method.

In the invention, development may be performed directly after exposure to light, but heating treatment (referred to as pre-heating) may be performed between the light exposure process and the development process. In regard to the conditions for the heating treatment, heating is preferably performed at a temperature within a range of from 60°C to 150°C for from 5 seconds to 5 minutes.

In the invention, development is preferably performed directly after exposure to light using the thermal-polymerization photosensitive composition, without pre-heating.

Development is performed by supplying the exposed planographic printing plate precursor to the automatic developing machine 10 of Fig. 1, and developing the planographic printing plate precursor using the negative-working developer liquid described above.

A water washing process (pre-washing with water) may be performed prior to the development process, to remove the protective layer. In the pre-washing with water, for example, tap water is used, and the regenerated water generated by the method according to the invention is also usable.

The pre-washing with water may be dispensed with when using the recycling method according to the invention. More specifically, in cases in which the protective layer and the image recording layer are simultaneously removed by the developer liquid, the viscosity of the developer liquid increases due to an increase in the amount of materials eluted to the developer liquid, and the amount of precipitates also increases. Therefore, pre-washing with water is generally performed. However, in the method according to the invention, the amount of waste liquid after concentration is reduced by recirculating regenerated water obtained from plate-making process waste liquid, whereby the replenishment amount of development replenisher liquid can be increased; as a result, problems do not arise even when the amount of dissolved matter in the development bath is increased, as compared to the case of performing pre-washing with water, due to removal of the protective layer and the image recording layer simultaneously in the development bath, and therefore pre-washing with water to remove only the protective layer is unnecessary.

After the exposure to light (or after subjected to the light exposure process and the heating process), the thermal-polymerization photosensitive planographic printing plate precursor is developed with the developer liquid described above, and further processed using water for water washing that includes aluminum ions and a chelating agent having the ability to form a water-soluble chelate compound.

The planographic printing plate obtained through the plate-making process described above may be subjected to post-treatment using a rinse liquid containing a surfactant or the like, and/or a desensitizing liquid containing gum arabic, a starch derivative, or the like, as described in, for example, JP-ANos. S54-8002, S55-115045, and S59-58431. Post-treatment of the planographic printing plate may be performed using any of various combinations of these treatments.

In plate-making for the photosensitive planographic printing plate precursor, it is effective subjecting the image after development to whole-surface post-heating or whole-surface light exposure, for the purpose of enhancing the image intensity/printing durability.

Extremely intense conditions may be used in the heating after development. Generally, the heating is performed at a heating temperature within a range of from 200°C to 500°C. With a temperature of heating after development within the above range, a sufficient image strengthening effect is obtained, and problems such as deterioration of the support and thermal decomposition of the image portion hardly occur.

The planographic printing plate obtained by the above processes is set in an offset printing machine, and employed for printing a great number of sheets.

Conventionally known plate cleaners for PS plates may be employed as a plate cleaners for use in removal of contaminants on the plate during printing, and examples thereof include CL-1, CL-2, CP, CN-4, CN, CG-1, PC-1, SR, IC (all trade names, manufactured by FUJIFILM Corporation).

### EXAMPLES

The invention will described based on examples below. The invention is not limited to the examples below. Note that "part" and "%" are used on a mass basis.

Experiments were carried out using a system according to the invention and using a negative-working photosensitive planographic printing plate precursor.

### Example 1

For the development of a newspaper CTP plate HN-NV manufactured by FUJIFILM Corporation (a photosensitive planographic printing plate precursor that includes a radical-polymerizable image recording layer compatible with a thermal LD at 800 nm to 850 nm and a protective layer), which is a negative-working photosensitive planographic printing plate precursor, after exposure to light, developer liquid HN-D (trade name) manufactured by FUJIFILM Corporation for a negative-working photosensitive planographic printing plate precursor and development replenisher liquid HN-DR (trade name) manufactured by FUJIFILM Corporation, were used. Developer liquid HN-D (trade name) is a concentrate liquid for the preparation of development initiation liquid used in the present embodiment, and was diluted with four times larger amount of water (on a mass basis) when fed into the automatic developing machine, to form development initiation liquid according to the invention. Development replenisher liquid HN-DR (trade name) was is a concentrate liquid for the preparation of development replenisher liquid used in the present embodiment, and was diluted with two times larger amount of water (on a mass basis) when supplied to the automatic developing machine, to form development replenisher liquid.

Plate-making process was performed for 3000 m² over one month, using the planographic printing plate precursor described above, the development initiation liquid described above, and the development replenisher liquid described above in combination with an automatic developing machine LP-1310 NEWS II (provided with a development means, a rinsing means (including a water washing means) and a gumming means), according to the system illustrated in Fig. 1.

During the processing period, the plate-making process waste liquid was processed using an XR-2000 (a heat-pump-type waste liquid concentration device manufactured by Takagi Refrigerating Co., Ltd.), as a result of which the waste liquid could be concentrated to 1/5 volume, the regenerated water contained no solvent components at all, and a portion of the regenerated water could be discharged to an ordinary sewer after being subjected to activated sludge treatment. A portion of the regenerated water was also used as rinse water for the planographic printing plate after development.

During the processing period, the composition of the developer liquid in the development bath of the automatic developing machine was as follows: the content of surfactant A (a sulfuric acid salt of an naphthol ethylene oxide adduce, which is exemplary compound (1)) was within a range of from 3% to 6%, the content of organic solvent having a boiling point of from 100°C to 300°C was from 0% to 0.05%, the content of trisodium citrate was from 0.1% to 0.8%, the content of silicate components was 0%, and the pH of the developer liquid was within a range of from 11.9 to 12.3

In regard to the conditions for development, the development temperature was 30°C, and the development time was 12 seconds. In regard to the conditions for concentrating the plate-making process waste liquid, the concentration temperature was 35°C, and the pressure was 32 mmHg. In regard to the conditions for cooling, cooling was performed at 5°C.

The developer liquid HN-D contained exemplary compound (1) at 25% by mass as a surfactant, but contained neither an organic solvent having a boiling point of from 100°C to 300°C nor a silicate component (silicic acid salt compound). The developer liquid HN-D contained potassium hydroxide at 9.5% by mass, and had a pH of 12.3.

The development replenisher liquid HN-DR contained exemplary compound (1) as a surfactant at 9% by mass, but contained neither an organic solvent having a boiling point of from 100°C to 300°C nor a silicate compound. The development replenisher liquid HN-DR had a trisodium citrate content of 2% by mass, contained potassium hydroxide at 9.5% by mass, and had a pH of 12.9.

### Example 2

For the development of a newspaper CTP plate HN-NV manufactured by FUJIFILM Corporation, which is a negative-working photosensitive planographic printing plate precursor, after exposure to light, developer liquid HN-D (trade name) manufactured by FUJIFILM Corporation for a negative-working photosensitive planographic printing plate precursor, and development replenisher liquid HN-DR (trade name) manufactured by FUJIFILM Corporation, were used. Similar to in Example 1, developer liquid HN-D (trade name) (a concentrate liquid for the preparation of development initiation liquid) was diluted with four times larger amount of water (on a mass basis) when fed into the automatic developing machine, to form a development initiation liquid. Development replenisher liquid HN-DR (trade name) (a concentrate liquid for the preparation of development replenisher liquid) was diluted with two times larger amount of water (on a mass basis) when supplied to the automatic developing machine, to form a development replenisher liquid.

Plate-making process was performed for 3000 m² over one month, using the planographic printing plate precursor described above, the development initiation liquid described above, and the development replenisher liquid described above in combination with an automatic developing machine LP-1310 NEWS II, according to the system illustrated in Fig. 1.

During the processing period, the composition of the developer liquid in the development bath of the automatic developing machine was as follows: the content of surfactant A (a sulfuric acid salt of naphthol ethylene oxide adduct, which is exemplary compound (1)) was within a range of from 3% to 6%; the content of organic solvent having a boiling point of from 100°C to 300°C was from 0% to 0.05%; the content of citric acid trisodium salt was from 0.1% to 0.8%; the content of silicate compound was 0%; and the pH of the developer liquid was within a range of from 11.9 to 12.3

In regard to the conditions for development, the development temperature was 30°C and the development time was 12 seconds. In regard to the conditions for concentrating the plate-making process waste liquid, the concentration temperature was 30°C and the pressure was 30 mmHg. In regard to the conditions for cooling, cooling was performed at 5°C.

The degree of concentration of the plate-making process waste liquid was 1/5, and the obtained regenerated water was used as diluent water for the preparation of a development replenisher liquid. During the dilution, the concentrate liquid for the preparation of development replenisher liquid was diluted with twice as much amount of the regenerated water as the amount of the concentrate liquid, to prepare development replenisher liquid.

Sediment did not accumulate in the development bath and the water-washing bath of the automatic developing machine after continuous processing, and contamination was hardly noticeable.

An XR-2000 manufactured by Takagi Refrigerating Co., Ltd. was used as the waste liquid concentration device.

An XR-R60 manufactured by Takagi Refrigerating Co., Ltd. was used as the distillatively-regenerated water reutilization device, and the regenerated water was delivered to a tank in the automatic developing machine, and reutilized as diluent water for the preparation of development replenisher liquid, as described above.

### Example 3

A developer liquid and a development replenisher liquid were prepared in the same manner as in Example 2, except that exemplary compound (1), which is a surfactant included in the developer liquid HN-D (trade name) (the concentrate liquid for the preparation of development initiation liquid) and the development replenisher liquid HN-DR (trade name) (the concentrate liquid for the preparation of development replenisher liquid), was replaced by a surfactant B (sodium tert-butyl naphthalene sulfonate).

More specifically, plate-making process was performed in the same manner as in Example 2, except that the surfactant A as a component of the developer liquid in the development bath of the automatic developing machine was replaced by the surfactant B (sodium tert-butyl naphthalene sulfonate) by using the concentrate liquid for the preparation of development initiation liquid and the concentrate liquid for the preparation of development replenisher liquid, each of which included the surfactant B, in place of the developer liquid HN-D and the development replenisher liquid HN-DR, respectively. As a result, processing similar to Example 1 was possible, sediment did not accumulate in the development bath and the water-washing bath of the automatic developing machine after continuous processing, and contamination was hardly noticeable.

### Example 4

A concentrate liquid for the preparation of development initiation liquid and a concentrate liquid for the preparation of development replenisher liquid were prepared by further including a silicate component (potassium silicate) at 0.5% by mass in the developer liquid HN-D (trade name) (the concentrate liquid for the preparation of development initiation liquid) and the development replenisher liquid HN-DR (trade name) (the concentrate liquid for the preparation of development replenisher liquid). Plate-making process was performed in the same manner as in Example 2, except that the concentrate liquid for the preparation of development initiation liquid and the concentrate liquid for the preparation of development replenisher liquid were used in place of the developer liquid HN-D and the development replenisher liquid HN-DR, respectively. As a result, processing similar to Example 1 was possible, and sediment did not accumulate in the development bath and the water-washing bath of the automatic developing machine after continuous processing, and contamination was hardly noticeable.

### Example 5

Processes were carried out in the same manner as in Example 3, except that the negative-working photosensitive planographic printing plate precursor was replaced by a TCC-353 manufactured by Eastman Kodak Company (a photosensitive planographic printing plate precursor that includes a radical-polymerizable image recording layer compatible with a thermal LD from 800 nm to 850 nm and a protective layer), and that the plate-making process was performed for 500 m² over 1 week. As a result, the plate-making process waste liquid could be concentrated to 1/4 volume, sediment did not accumulate in the development bath and the water-washing bath of the automatic developing machine after continuous processing, and contamination was hardly noticeable.

### Comparative Example 1

Plate-making process was performed in the same manner as in Example 2, except that the dilution amounts of the developer liquid HN-D (trade name) (the concentrate liquid for use the preparation of development initiation liquid) and the development replenisher liquid HN-DR (trade name) (the concentrate liquid for the preparation of development replenisher liquid) were adjusted such that the concentration of surfactant A in the development bath became 0.8%. As a result, precipitation occurred in the concentration device for plate-making process waste liquid, and concentration could not be performed.

### Comparative Example 2

Plate-making process was performed as in Example 2, except that the type of surfactant was changed from that contained in the developer liquid HN-D (trade name) (concentrate liquid for the preparation of development initiation liquid) and the development replenisher liquid HN-DR (trade name) (concentrate liquid for the preparation of development replenisher liquid) to sodium dodecyl benzene sulfonate, which is an anionic surfactant not having a naphthalene skeleton, and that the development replenisher liquid was regulated to have a content of surfactant at the time of being supplied for use in development processing of 4% by mass. As a result, precipitation occurred in the concentration device for plate-making process waste liquid, and concentration could not be performed.

### Comparative Example 3

Plate-making process was performed in the same manner as in Example 2, except that the type and amount of surfactant were changed from those in the development replenisher liquid HN-DR (trade name) (concentrate liquid for the preparation of development replenisher liquid) to 2% LIPOMIN (trade name, manufactured by Takamoto Oil & Fat Co., Ltd.), which is a surfactant having a carboxyl group salt and an amino group in the same molecule, and 2% sodium dodecyl benzene sulfonate. As a result, foaming occurred in the concentration device for plate-making process waste liquid, plate-making process waste liquid flowed into the regenerated water, and usable regenerated water could not be obtained.

### Comparative Example 4

A development replenisher liquid was prepared in the same manner as in Example 3, except that the type and amount of surfactant was changed from those in the development replenisher liquid HN-DR (trade name) (the concentrate liquid for the preparation of development replenisher liquid) to 0.8% of surfactant B (sodium tert-butyl naphthalene sulfonate) and 0.2% sodium dodecyl benzene sulfonate, and that the development replenisher liquid at the time of being supplied to development included a silicate component (potassium silicate) at 2%. Except for using the development replenisher liquid prepared in this way, plate-making process was performed in the same manner as in Example 3. As a result, adhesion occurred in the concentration device for plate-making process waste liquid, concentration efficiency lowered, a discharge malfunction occurred after one week, and concentration of plate-making process waste liquid could no longer be performed.

### Comparative Example 5

Plate-making process was performed in the same manner as in Example 2, except that benzyl alcohol was further added to developer liquid HN-D (trade name) (the concentrate liquid for the preparation of development initiation liquid) and development replenisher liquid HN-DR (trade name) (the concentrate liquid for the preparation of development replenisher liquid) so as to provide a benzyl alcohol concentration of 2.5% at the time of being supplied to the development. The printing durability of highlight portions of 10% or less of the planographic printing plate after processing lowered to 50% of that in Example 2, and a planographic printing plate capable of withstanding practical use was not obtained.

### Example 6

After a negative-working CTP photosensitive planographic printing plate precursor LP-NNV manufactured by FUJIFILM Corporation (a photosensitive planographic printing plate precursor that includes a radical-polymerizable image recording layer compatible with a violet LD 405 nm and a protective layer) was exposed to light, plate-making process was performed using an automatic developing machine INTERPLATER 135 (, which includes a pre-heating means, a means for pre-washing with water for the protective layer, a development means, a rinse means (water-washing means), and a gumming means) with developer liquid LP-DS (trade name) manufactured by FUJIFILM Corporation for a negative-working photosensitive planographic printing plate precursor and development replenisher liquid LP-DRN (trade name) manufactured by FUJIFILM Corporation, according to the system illustrated in Fig. 1. This plate-making process was performed for 1000 m² over one month. In the automatic developing machine INTERPLATER 135, a process of pre-washing with water was performed, before development, to remove the protective layer.

During the processing period, plate-making process waste liquid was processed using an XR-2000, and the plate-making process waste liquid could be concentrated to 1/4 volume.

During this period, the composition of the developer liquid in the development bath of the automatic developing machine was as follows: the concentration of surfactant C (a naphthol ethylene oxide adduct, which is exemplary compound Y-1) was within a range of from 3% to 6%; the content of organic solvent having a boiling point within a range of from 100°C to 300°C was from 0% to 0.05%; and the content of silicate components was 0%. Sediment did not accumulate in the development bath and the water-washing bath of the automatic developing machine after continuous processing, and contamination was hardly noticeable.

The regenerated water was used as rinse water.

Developer liquid LP-DS includes surfactant C (exemplary compound Y-1) as a surfactant at 5% by mass, and includes neither an organic solvent having a boiling point within a range of from 100°C to 300°C nor a silicate compound. The pH of developer liquid LP-DS had been adjusted to 12.0 using potassium hydroxide.

Development replenisher liquid LP-DRN includes surfactant C (exemplary compound Y-1) as a surfactant at 5% by mass, and includes neither an organic solvent having a boiling point within a range of from 100°C to 300°C nor a silicate compound. The pH of development replenisher liquid LP-DRN had been adjusted to 12.8 using potassium hydroxide.

### Example 7

After a negative-working CTP photosensitive planographic printing plate precursor LH-NN2 manufactured by FUJIFILM Corporation (a photosensitive planographic printing plate precursor that includes a radical-polymerizable image recording layer compatible with a thermal LD of from 800 nm to 850 nm and a protective layer) was exposed to light, plate-making process was performed using an automatic developing machine INTERPLATER 135 (, which includes a development means, a rinse means (water-washing means), and a gumming means) in combination with developer liquid LP-DS (trade name) and development replenisher liquid LP-DRN (trade name), according to the system illustrated in Fig. 1. This plate-making process was performed for 1000 m² over one month. In the present embodiment, the pre-heating and the pre-washing with water were not performed.

During the processing period, plate-making process waste liquid was processed using an XR-2000, and the plate-making process waste liquid could be concentrated to 1/4 volume. Sediment did not accumulate in the development bath and the water-washing bath of the automatic developing machine after continuous processing, and contamination was hardly noticeable.

The regenerated water was used as rinse water.

During this period, the composition of the developer liquid in the development bath of the automatic developing machine was as follows: the content of surfactant C (a naphthol ethylene oxide adduct) was within a range of from 3% to 6%; the content of organic solvent having a boiling point within a range of from 100°C to 300°C was from 0% to 0.05%; the content of silicate component was 0%; and the pH of the developer liquid was within a range of from 11.9 to 12.2.

## Claims

1. A method of recycling waste liquid from a plate-making process for a planographic printing plate precursor, the method comprising:
performing, in an automatic developing machine for developing a photosensitive planographic printing plate precursor after exposure to light, a plate-making process using a development replenisher liquid, the planographic printing plate precursor including a radical-polymerizable image recording layer on a support, the plate-making process including developing a planographic printing plate precursor after exposure to light, the development replenisher liquid including at least one selected from the group consisting of anionic surfactants having a naphthalene skeleton and nonionic surfactants having a naphthalene skeleton at a total content of from 1% by mass to 10% by mass, the development replenisher liquid including no organic solvent having a boiling point within a range of from 100°C to 300°C or including organic solvent having a boiling point within a range of from 100°C to 300°C at a total content of no more than 2% by mass, and the development replenisher liquid having a pH of from 10 to 13;
concentrating, by evaporating, the plate-making process waste liquid discharged during the plate-making process using a waste liquid concentration device, such that the ratio of the volume of the plate-making process waste liquid after concentration to the volume of the plate-making process waste liquid before concentration is within a range of from 1/10 to 1/2, thereby separating the plate-making process water liquid into water vapor and a waste liquid concentrate;
condensing the separated water vapor to obtain regenerated water; and
using the obtained regenerated water as at least one of diluent water for preparation of the development replenisher liquid for the automatic development machine or rinse water for the automatic developing machine.

2. The method of recycling plate-making process waste liquid according to claim 1, wherein the development replenisher liquid further includes at least one organic acid or at least one salt thereof at a total content of from 0.05% by mass to 5% by mass.

3. The method of recycling plate-making process waste liquid according to claim 1 or claim 2, wherein the total content of silicate component in the development replenisher liquid is 1% by mass or less.

4. The method of recycling plate-making process waste liquid according to any one of claims 1 to 3, wherein the anionic surfactant having a naphthalene skeleton includes at least one anionic surfactant selected from the group consisting of sulfonic acid salts and sulfuric acid salts.

5. The method of recycling plate-making process waste liquid according to any one of claims 1 to 4, wherein the photosensitive planographic printing plate precursor includes a protective layer provided on the radical-polymerizable image recording layer, and washing of the protective layer with water is further performed in the automatic developing machine prior to the developing.

6. The method of recycling plate-making process waste liquid according to any one of claims 1 to 5, wherein the waste liquid concentration device includes a heating means, and the concentrating, by evaporating, of the plate-making process waste liquid is performed by heating the plate-making process waste liquid using the heating means.

7. The method of recycling plate-making process waste liquid of claim 6, wherein the waste liquid concentration device further includes a pressure reducing means that reduces pressure inside the waste liquid concentration device, and the heating of the plate-making process waste liquid is performed under a condition of reduced pressure.

8. The method of recycling plate-making process waste liquid of claim 6 or claim 7, wherein the heating means of the waste liquid concentration device includes a heat pump that includes a heat release section and a heat absorption section, and the heating means heats the plate-making process waste liquid at the heat release section of the heat pump to generate water vapor, and cools the water vapor at the heat absorption section of the heat pump.

9. The method of recycling plate-making process waste liquid according to any one of claims 1 to 8, further including recovering a concentrate formed after water vapor is separated from the plate-making process waste liquid, the concentrate having been concentrated by the concentrating by evaporating in the waste liquid concentration device, in a recovery tank by applying pressure to the concentrate using a pump.

## Patentansprüche

1. Verfahren zum Recyceln von Abfallflüssigkeit aus einem Plattenherstellungsprozess für einen Flachdruckplattenvorläufer, wobei das Verfahren umfasst:
Durchführen eines Plattenherstellungsprozesses in einer automatischen Entwicklungsvorrichtung zum Entwickeln eines fotoempfindlichen Flachdruckplattenvorläufers nach der Belichtung unter Verwendung einer Entwicklungs-Nachfüllflüssigkeit, wobei der Flachdruckplattenvorläufer eine radikalisch polymerisierbare Bildaufzeichnungsschicht auf einem Träger umfasst, worin der Plattenherstellungsprozess das Entwickeln eines Flachdruckplattenvorläufers nach der Belichtung umfasst, worin die Entwicklungs-Nachfüllflüssigkeit mindestens eines umfasst, ausgewählt aus der Gruppe bestehend aus anionischen Tensiden mit einem Naphthalingerüst und nicht-ionischen Tensiden mit einem Naphthalingerüst, in einer Gesamtmenge von 1 Masse-% bis 10 Masse-%, wobei die Entwicklungs-Nachfüllflüssigkeit kein organisches Lösungsmittel mit einem Siedepunkt innerhalb des Bereichs von 100°C bis 300°C umfasst oder ein organisches Lösungsmittel mit einem Siedepunkt innerhalb des Bereichs von 100°C bis 300°C in einem Gesamtgehalt von nicht mehr als 2 Masse-% umfasst, und worin die Entwicklungs-Nachfüllflüssigkeit einen pH-Wert von 10 bis 13 aufweist;
Konzentrieren der Plattenherstellungsprozess-Abfallflüssigkeit, die während des Plattenherstellungsprozesses verworfen wird, durch Verdampfen unter Verwendung einer Abfallflüssigkeit-Konzentrationsvorrichtung, so dass das Verhältnis des Volumens der Plattenherstellungsprozess-Abfallflüssigkeit nach der Konzentration zu dem Volumen der Plattenherstellungsprozess-Abfallflüssigkeit vor der Konzentration innerhalb eines Bereichs von 1/10 bis 1/2 liegt, wodurch die Plattenherstellungsprozess-Abfallflüssigkeit in Wasserdampf und ein Abfallflüssigkeitskonzentrat getrennt wird;
Kondensieren des abgetrennten Wasserdampfs, um regeneriertes Wasser zu erhalten; und
Verwenden des erhaltenen, regenerierten Wassers als zumindest eines von Verdünnungswasser für die Herstellung der Entwicklungs-Nachfüllflüssigkeit für die automatische Entwicklungsmaschine oder als Spülwasser für die automatische Entwicklungsmaschine.

2. Verfahren zum Recyceln von Plattenherstellungsprozess-Abfallflüssigkeit gemäß Anspruch 1, worin die Entwicklungs-Nachfüllflüssigkeit ferner zumindest eine organische Säure oder zumindest ein Salz hiervon in einem Gesamtgehalt von 0,05 Masse-% bis 5 Masse-% enthält.

3. Verfahren zum Recyceln von Plattenherstellungsprozess-Abfallflüssigkeit gemäß Anspruch 1 oder Anspruch 2, worin der Gesamtgehalt der Silikatkomponente in der Entwicklungs-Nachfüllflüssigkeit 1 Masse-% oder weniger beträgt.

4. Verfahren zum Recyceln von Plattenherstellungsprozess-Abfallflüssigkeit gemäß irgendeinem der Ansprüche 1 bis 3, worin das anionische Tensid mit einem Naphthalingerüst zumindest ein anionisches Tensid umfasst, ausgewählt aus der Gruppe bestehend aus Sulfonsäuresalzen und Schwefelsäuresalzen.

5. Verfahren zum Recyceln von Plattenherstellungsprozess-Abfallflüssigkeit gemäß irgendeinem der Ansprüche 1 bis 4, worin der fotoempfindliche Flachdruckplattenvorläufer eine Schutzschicht, die auf der radikalisch polymerisierbaren Bildaufzeichnungsschicht vorgesehen ist, umfasst und ferner das Waschen der Schutzschicht mit Wasser in der automatischen Entwicklungsmaschine vor dem Entwickeln durchgeführt wird.

6. Verfahren zum Recyceln von Plattenherstellungsprozess-Abfallflüssigkeit gemäß irgendeinem der Ansprüche 1 bis 5, worin die Abfallflüssigkeits-Konzentrationsvorrichtung ein Erwärmungsmittel umfasst und das Konzentrieren der Plattenherstellungsprozess-Abfallflüssigkeit durch Verdampfen durch Erwärmen der Plattenherstellungsprozess-Abfallflüssigkeit unter Verwendung des Erwärmungsmittels durchgeführt wird.

7. Verfahren zum Recyceln von Plattenherstellungsprozess-Abfallflüssigkeit gemäß Anspruch 6, worin die Abfallflüssigkeits-Konzentrationsvorrichtung ferner ein Mittel zum reduzieren des Drucks umfasst, welches den Druck innerhalb der Abfallflüssigkeits-Konzentrationsvorrichtung herabsetzt, und das Erwärmen der Plattenherstellungsprozess-Abfallflüssigkeit unter Bedingungen von reduziertem Druck durchgeführt wird.

8. Verfahren zum Recyceln von Plattenherstellungsprozess-Abfallflüssigkeit gemäß Anspruch 6 oder Anspruch 7, worin das Erwärmungsmittel der Abfallflüssigkeits-Konzentrationsvorrichtung eine Wärmepumpe umfasst, die einen Wärmeabführbereich und einen Wärmeaufnahmebereich umfasst, und worin das Erwärmungsmittel die Plattenherstellungsprozess-Abfallflüssigkeit an dem Wärmeabführbereich der Wärmepumpe erwärmt, um Wasserdampf zu erzeugen, und den Wasserdampf an dem Wärmeaufnahmebereich der Wärmepumpe kühlt.

9. Verfahren zum Recyceln von Plattenherstellungsprozess-Abfallflüssigkeit gemäß irgendeinem der Ansprüche 1 bis 8, ferner umfassend das Rückgewinnen eines Konzentrats, das gebildet wird, nachdem Wasserdampf von der Plattenherstellungsprozess-Abfallflüssigkeit abgetrennt worden ist, wobei das Konzentrat durch das Konzentrieren durch Verdampfen in der Abfallflüssigkeits-Konzentrationsvorrichtung konzentriert worden ist, in einem Rückgewinnungstank, durch Anwenden von Druck auf das Konzentrat unter Verwendung einer Pumpe.

## Revendications

1. Procédé de recyclage d'un déchet liquide provenant d'un procédé de fabrication de plaque pour un précurseur de plaque d'impression planographique, le procédé comprenant :
la mise en oeuvre, dans une machine de développement automatique pour développer un précurseur de plaque d'impression planographique photosensible après exposition à une lumière, d'un procédé de fabrication de plaque en utilisant un liquide régénérateur de développement, le précurseur de plaque d'impression planographique comprenant une couche d'enregistrement d'image polymérisable par voie radicalaire sur un support, le procédé de fabrication de plaque comprenant le développement d'un précurseur de plaque d'impression planographique après exposition à une lumière, le liquide régénérateur de développement comprenant au moins un sélectionné dans le groupe constitué de tensioactifs anioniques ayant un squelette de naphtalène et de tensioactifs non ioniques ayant un squelette de naphtalène à une teneur totale de 1 % en masse à 10 % en masse, le liquide régénérateur de développement ne comprenant aucun solvant organique ayant un point d'ébullition situé dans une plage allant de 100 °C à 300 °C ou comprenant un solvant organique ayant un point d'ébullition situé dans une plage allant de 100 °C à 300 °C à une teneur totale de pas plus de 2 % en masse, et le liquide régénérateur de développement ayant un pH allant de 10 à 13 ;
la concentration, par évaporation, du déchet liquide de procédé de fabrication de plaque évacué lors du procédé de fabrication de plaque en utilisant un dispositif de concentration de déchet liquide, de façon à ce que le rapport du volume du déchet liquide de procédé de fabrication de plaque après concentration sur le volume du déchet liquide de procédé de fabrication de plaque avant concentration soit situé dans une plage allant de 1/10 à 1/2, en séparant ainsi le liquide aqueux de procédé de fabrication de plaque en vapeur d'eau et en concentré de déchet liquide ;
la condensation de la vapeur d'eau séparée pour obtenir de l'eau régénérée ; et
l'utilisation de l'eau régénérée obtenue comme au moins une parmi de l'eau de dilution pour la préparation du liquide régénérateur de développement pour la machine de développement automatique ou de l'eau de rinçage pour la machine de développement automatique.

2. Procédé de recyclage d'un déchet liquide de procédé de fabrication de plaque selon la revendication 1, dans lequel le liquide régénérateur de développement comprend en outre au moins un acide organique ou au moins un sel de celui-ci à une teneur totale allant de 0,05 % en masse à 5 % en masse.

3. Procédé de recyclage d'un déchet liquide de procédé de fabrication de plaque selon la revendication 1 ou 2, dans lequel la teneur totale en composant de silicate dans le liquide régénérateur de développement est de 1 % en masse ou moins.

4. Procédé de recyclage d'un déchet liquide de procédé de fabrication de plaque selon l'une quelconque des revendications 1 à 3, dans lequel le tensioactif anionique ayant un squelette de naphtalène comprend au moins un tensioactif anionique sélectionné dans le groupe constitué de sels d'acide sulfonique et de sels d'acide sulfurique.

5. Procédé de recyclage d'un déchet liquide de procédé de fabrication de plaque selon l'une quelconque des revendications 1 à 4, dans lequel le précurseur de plaque d'impression planographique photosensible comprend une couche protectrice fournie sur la couche d'enregistrement d'image polymérisable par voie radicalaire, et le lavage de la couche protectrice avec de l'eau est réalisé en outre dans la machine de développement automatique avant le développement.

6. Procédé de recyclage d'un déchet liquide de procédé de fabrication de plaque selon l'une quelconque des revendications 1 à 5, dans lequel le dispositif de concentration de déchet liquide comprend un moyen de chauffage, et la concentration, par évaporation, du déchet liquide de procédé de fabrication de plaque est réalisée en chauffant le déchet liquide de procédé de fabrication de plaque en utilisant le moyen de chauffage.

7. Procédé de recyclage d'un déchet liquide de procédé de fabrication de plaque selon la revendication 6, dans lequel le dispositif de concentration de déchet liquide comprend en outre un moyen de réduction de pression qui réduit une pression à l'intérieur du dispositif de concentration de déchet liquide, et le chauffage du déchet liquide de procédé de fabrication de plaque est réalisé dans une condition de pression réduite.

8. Procédé de recyclage d'un déchet liquide de procédé de fabrication de plaque selon la revendication 6 ou 7, dans lequel le moyen de chauffage du dispositif de concentration de déchet liquide comprend une pompe à chaleur qui comprend une section de dégagement de chaleur et une section d'absorption de chaleur, et le moyen de chauffage chauffe le déchet liquide de procédé de fabrication de plaque au niveau de la section de dégagement de chaleur de la pompe à chaleur pour générer de la vapeur d'eau, et refroidit la vapeur d'eau au niveau de la section d'absorption de chaleur de la pompe à chaleur.

9. Procédé de recyclage d'un déchet liquide de procédé de fabrication de plaque selon l'une quelconque des revendications 1 à 8, comprenant en outre la récupération d'un concentré formé après que la vapeur d'eau soit séparée du déchet liquide de procédé de fabrication de plaque, le concentré ayant été concentré par la concentration par évaporation dans le dispositif de concentration de déchet liquide, dans une cuve de récupération par l'application d'une pression au concentré en utilisant une pompe.
